# EUROPEAN PATENT APPLICATION

(11) **EP 4 766 078 A1**
(43) Date of publication of application: **24.06.2026**
(21) Application number: 25224911.5
(22) Date of filing: 18.12.2025
(51) Int. Cl.: H10D 30/01, H10D 30/47, H10D 64/00, H10D 64/23, H10D 62/85

(54) **FABRICATION PROCESS FOR HEMT DEVICES WITH FIELD PLATES**

(30) Priority: 19.12.2024 US 202418987304
(71) Applicant: NXP USA, Inc., Austin, TX 78735 (US)
(72) Inventor: ZHU, Congyong, 5656AG Eindhoven (NL); CURRIER, David Robert, 5656AG Eindhoven (NL); COCHRAN, David Garret, 5656AG Eindhoven (NL); FOSTER, Elijah Blue, 5656AG Eindhoven (NL); HALE, Gregory David, 5656AG Eindhoven (NL); AHAMED, Faruque, 5656AG Eindhoven (NL)
(74) Representative: Schwarzweller, Thomas

(57) **Abstract**

Modified fabrication processes for transistors with field plates such as gallium nitride heterostructure transistors reduce exposure of surfaces near the transistor channel to mitigate the risk of damage and performance degradation arising from exposure to sensitive surfaces and interfaces to high temperatures and etch-induced damage. Such processes include sequencing of dielectric formation and patterning that allows formation of gate and field plate electrodes after high-temperature processing steps. Passivation layers which can also function as etch stop layers for other dielectric materials enable protection of the channel region during dry etching processes followed by selective wet etching to remove the passivation layer immediately prior to gate electrode formation and other steps. Such methods can also enable surface modification processes to be performed to selectively enhance channel conductivity followed by passivation of modified surfaces to preserve enhanced conductivity during subsequent processing steps.

## Description

### TECHNICAL FIELD

Embodiments of the subject matter described herein relate generally to transistors with field plates and methods for fabricating such devices.

### BACKGROUND

Semiconductor devices find application in a wide variety of electronic components and systems. High power, high frequency transistors find application in radio frequency (RF) systems and power electronics systems. Gallium nitride (GaN) device technology is particularly suited for these RF power and power electronics applications due to its superior electronic and thermal characteristics. In particular, the high electron velocity and high breakdown field strength of GaN make devices fabricated from this material ideal for RF power amplifiers and high-power switching applications. Field plates are used to reduce gate-drain feedback capacitance and to increase device breakdown voltage in high frequency transistors. Accordingly, there is a need for semiconductor and, in particular, GaN transistors with field plates.

### SUMMARY

In an example embodiment, a method of fabricating a semiconductor device includes receiving a semiconductor substrate having a channel region operable as a transistor channel. The channel region extends between a first current terminal region at a first end of the channel region and a second current terminal region at a second end of the channel region. A first dielectric stack is disposed directly on a top surface of the channel region. The first dielectric stack includes a first dielectric layer; and a first etch stop layer disposed directly on the first dielectric layer.

The method also includes patterning the first dielectric stack to simultaneously form: a first opening in the first dielectric stack located between the first end of the channel region and the second end of the channel region; and a second opening that passes through at least part of the first dielectric stack between the first opening and the second end of the channel region.

The method also includes forming a dielectric spacer layer above the patterned first dielectric stack and within the first and second apertures; and patterning the spacer layer to selectively remove the spacer layer above the first opening.

The method also includes forming an electrically conductive gate electrode that directly contacts the top surface of the channel region in a gate aperture having a location defined by the first opening; forming an interlayer dielectric layer above the gate electrode; selectively removing the interlayer dielectric layer to form a field plate aperture with a location defined by the second opening; and forming an electrically-conductive field plate electrode in the field plate aperture.

### BRIEF DESCRIPTION OF THE DRAWINGS

The present disclosure is illustrated by way of examples, embodiments and the like and is not limited by the accompanying figures, in which like reference numbers indicate similar elements. The figures along with the detailed description are incorporated and form part of the specification and serve to further illustrate examples, embodiments and the like, and explain various principles and advantages, in accordance with the present disclosure, wherein:
FIG. 1 is a schematic cross-sectional view of an example transistor according to one or more embodiments.
FIG. 2A and FIG. 2B are flow diagrams illustrating steps in example processes for fabricating transistors with field plates such as the transistor of FIG. 1 according to embodiments herein.
2A and FIG. 2B illustrate example steps in an example process for fabricating transistors with field plates according to embodiments herein.
FIG. 3 is a schematic cross-sectional view of another example transistor according to one or more embodiments.
FIG. 4A and FIG. 4B illustrate steps are flow diagrams illustrating steps in additional example processes for fabricating transistors with field plates according to embodiments herein.
FIG. 5 is a cross-sectional schematic view showing portions of a transistor according to one or more embodiments in greater detail.
FIG. 6 is a cross-sectional schematic view of another example transistor with a field plate which according to one or more embodiments
FIG. 7 is a flow diagram illustrating steps of an example process that is suitable for fabricating transistors according to one or more embodiments (e.g., the transistor of FIG. 6).
FIG. 8A shows another example transistor according to one or more embodiments.
FIG. 8B shows another example transistor according to one or more embodiments.
FIG. 8C shows the gate of the transistor in greater detail.
FIG. 9A is a flow diagram illustrating steps in an example process for fabricating a transistor according to one or more embodiments such as the transistor of FIG. 8A or Fig. 8B.
FIG. 9B depicts steps and which are performed in one or more embodiments in a process such as the process of FIG. 9A.
FIG. 9C depicts steps and which are performed in one or more embodiments in a process such as the process of FIG. 9A.
FIG. 10 depicts an alternative process which is related to the process of FIG. 9A.
FIG. 11 is a cross-sectional view of another example transistor according to one or more embodiments.
FIG. 12 is a flow diagram showing illustrating steps an example process suitable for fabricating a transistor such as the transistor of FIG. 11 and related transistors according to one or more embodiments.
FIG. 13 is a cross-sectional view of another example transistor according to one or more embodiments.
FIG. 14 is a flow diagram showing illustrating steps an example process suitable for fabricating a transistor such as the transistor of FIG. 13 and related transistors according to one or more embodiments.

### DETAILED DESCRIPTION

The following detailed description provides examples for the purposes of understanding and is not intended to limit embodiments of this disclosure and uses of the same. It will be understood that numerous related techniques and devices and variations of the same are disclosed for ease of understanding and that these techniques and variations can be combined in numerous ways. It will also be understood that the Applicant has chosen to claim particular combinations of the disclosed techniques and/or devices and that not every combination disclosed is claimed. Furthermore, there is no intention to be bound by any expressed or implied theory presented in the preceding technical field, background, or the detailed description.

For simplicity and clarity of illustration, elements in the drawings are not necessarily drawn to scale. For example, the dimensions of some of the elements or regions in the figures may be exaggerated relative to other elements or regions to help improve understanding of embodiments of the invention. Directional references such as "top," "bottom," "left," "right," "above," "below," and so forth, unless otherwise stated, are not intended to require any preferred orientation, and are made with reference to the orientation of the corresponding figure or figures for purposes of illustration. In addition, the Figures and Detailed Description may omit well-known and conventional features for clarity.

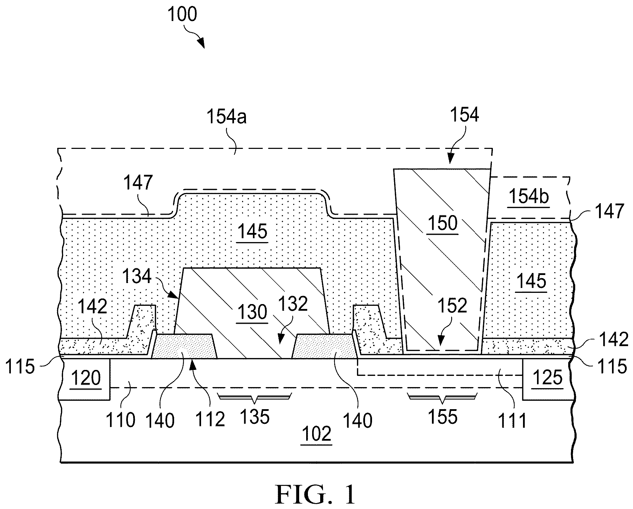

FIG. 1 is a schematic cross-sectional view of example transistor according to one or more embodiments. The transistor 100 is formed on a semiconductor substrate 102 and has a channel region 110 near a top surface 112 of the substrate 102. The transistor 100 includes a first current terminal 120 electrically coupled to a first end of the channel region 110 and a second current terminal 125 electrically coupled to a second end of the channel region 110 opposite the first current terminal 120. It will be understood that features of the transistor 100 above (and features of other example transistors herein) may be compatible with various transistor technologies. For instance, the transistor 100 and/or any other example transistor according to embodiments herein may be a metal-MOSFET or MISFET fabricated on a silicon substrate or any other suitable semiconductor substrate. For instance, in one or more embodiments, a transistor such as the transistor 100 is a III-V compound semiconductor-based high-electron-mobility transistor ("HEMT"), otherwise known as a heterostructure field effect transistor ("HFET"). In such embodiments the effective semiconductor channel may be a 2D electron gas ("2DEG") formed at a semiconductor heterojunction disposed with the channel region 110 according to known techniques.

A passivation material 115 (e.g., a dielectric) is disposed on the top surface 112 overlying the channel region 110. The first current terminal 120 and the second current terminal 125 may be formed by any suitable methods. For example, they may be appropriately doped regions within the semiconductor substrate 102, or as metallic contacts deposited within recesses in the substrate 102 or on the surface of the substrate 102. The current terminals 120,125 can be overlaid by respective metallic contacts (not shown) that pass through one or more dielectric layers to make direct electrical contact to the current terminals or contacted in any other suitable manner.

The passivation material 115 is overlaid as shown by dielectric materials 142 and 145 (an interlayer dielectric 145). A conductive first electrode (hereinafter a control electrode or gate 130) contacts the channel region 110 through an aperture 135 in the passivation material 115 and the dielectric materials 140, 142. As shown, the gate 130 has a first end 132 that contacts the channel region 110 within the aperture and optionally has a second end 134 that overhangs the passivation the dielectric material 140. Although the gate 130 is depicted as having vertical sidewalls, it will be understood that the gate 130 may have any suitable geometry. For instance, the first end 132 of the control electrode may have sidewalls that are curved or slanted. Similarly, the second end 134 of the gate 130 may have sidewalls that are curved or slanted and the top surface (farthest from the channel region 110) my have any suitable geometry. The gate 130 is disposed in between the first current terminal 120 and the second current terminal 125 along the length of the channel region 110.

It will be appreciated that the first current terminal 120 may be operated, for example, as a source terminal of the transistor 100 and the second current terminal 125 may be operated, for example, as a drain terminal of the transistor 100. It also be understood that the gate 130 is suitable for use as a control electrode of the transistor 100 such that, when a suitable bias voltage is applied to the gate 130, the channel region 110 is configured to provide an electrically conductive path between the first current terminal 120 and the second current terminal 125.

Additional dielectric material overlies the gate 130 and various portions of the channel region 110. For example, as shown in FIG. 1, in one or more embodiments, the interlayer dielectric material 145 overlies gate and, in some areas, it also overlies the dielectric material 140, or the dielectric material 142 and the passivation material 115. As shown in FIG. 1, the transistor 100 also includes a second electrode (hereinafter a field plate 150) with a first end 152 disposed above the channel region 110 in between gate 130 and the second current terminal 125 and a second end 154 that extends away from the substrate 102. As shown, the field portion of the field plate 150 that is closest to the channel region 110 is disposed within an aperture 155 in the dielectric material 142 and additional portions of the field plate 150 are disposed within a wider aperture in the interlayer dielectric material 145. As shown, in or more embodiments a portion of the field plate 150 may overlie the dielectric material 142 and also the interlayer dielectric material 145 in an area that is between the aperture 155 and the current terminal 125 (which may be operable as the drain of the transistor 100).

It will understood that only a portion of the field plate 150 is shown and that a field plate such as the field plate 150 can be left "floating" (i.e., not directly connected to any other part of the transistor), coupled to a fixed potential reference such as a supply voltage terminal or a ground terminal or coupled to another part of the transistor such as a gate such as the gate 130 or a source or drain terminal (e.g., a current terminal 120 or 125). As one nonlimiting example, the field plate 150 can include a portion (e.g., a portion 154a indicated by dashed lines) which overlies the gate 130 and extends further over the channel region 110. In this example the field plate 150 can also directly contact the current terminal 120, configured as a source of the transistor 100. In another nonlimiting example, the field plate 150 can include a portion (e.g., a portion 154b indicated by dashed lines) that extends toward the current terminal 125. In addition, in one or more embodiments, the aperture 155 can be formed only in the interlayer dielectric 145 such that the second end 154 of the field plate 150 is disposed on the dielectric material 142 rather than on the passivation material 115.

It will be understood that, when the first current terminal 120 is operated as a source terminal of the transistor 100, the field plate 150 may be configured to operate as source-coupled field plate. The field plate 150 may be coupled to the current terminal 120 (operable as the source of the transistor 100) via one or more additional electrically conductive interconnects which are not pictured. In one or more embodiments, the field plate 150 may extend in one or more locations to contact the current terminal 120 directly (i.e., in the cross-sectional plane pictured or in or more other cross-sectional planes of the transistor 100). In the transistor 100, the conductance of the channel region 110 during operation of the transistor 100 will be influenced by the electrical potential of the gate 130 and the field plate 150. It will be appreciated that the field plate 150 is capacitively coupled to the channel region 110, primarily across the passivation material 115. Meanwhile the field plate 150 is also capacitively coupled to the gate 130, primarily across the interlayer dielectric material 145.

In one or more embodiments, additional passivation material 147 is deposited within the field plate aperture 155 before formation of the field plate 150. In one or more such embodiments, the passivation material 115 is removed from the bottom of the aperture 155 before the field plate 150 is formed.

Generally, a field plate such as the field plate 150 when coupled to a source terminal of a transistor may be used to reduce gate-to-drain feedback capacitance ("C_{GD}") in transistors such as the transistor 100 when compared to otherwise similar transistors lacking such a field plate. However, the addition of a source-coupled field plate spaced apart from a control electrode such as the gate 130 will also tend to introduce additional capacitance between the gate and the source ("C_{GS}") which is often an undesirable trade-off. In embodiments herein, multiple dielectric layers may be used to realize a desired value for C_{GD} while mitigating the additional C_{GS} introduced by the field plate. In addition, the shape of a field plate electrode, particularly near a channel region (e.g., the first end 152 of the field plate 150) can influence the electric field distribution in the channel region which can in turn affect performance characteristics of the transistor such as breakdown voltage, as one nonlimiting example.

It will be understood that, in or more embodiments, various dielectric layers and electrodes described herein may be jointly configured and arranged to achieve certain performance metrics or other device characteristics and that such metrics may be defined in absolute or relative terms. Non-limiting examples include absolute capacitance values such as C_{GD} and/or C_{GS} as well as ratios between such capacitance values. These and other capacitance values may be expressed in term of absolute capacitances or capacitances per unit of cross-sectional area or per unit of length.

In the transistor 100 and related transistors according to embodiments described herein, the use of multiple dielectric layers configured as described may confer certain advantages. Specifically, the relative dielectric constants and thicknesses of each of these materials may be chosen to achieve desired performance characteristics and to facilitate various fabrication procedures in embodiments herein. In one or more embodiments, the passivation material 115 is a silicon oxide or an aluminum oxide. In one or more embodiments, and dielectric material 140 is a nitride, and dielectric material 142 is also a nitride. For instance, in the example of FIG. 1, the relative thicknesses and dielectric constant of the passivation material 115 will tend to determine the effect of the field plate 150 (operating as a source-coupled field plate) on the channel region 110 and C_{GD} of the transistor 100 (i.e., the capacitance between the gate 130 and the second current terminal 125). Meanwhile, the dielectric constants and thicknesses of the dielectric materials 140, 142 and 145 will largely determine the additional C_{GS} penalty. Thus, a material with a relatively high dielectric constant may be chosen for the passivation material 115 to maximize the influence of the field plate 150 on the channel region 110. Thus, it will be understood that the C_{GS} penalty introduced by the portion of the field plate 150 overlying the gate 130 can be mitigated by the presence of the interlayer dielectric material 145 in at least two ways according to embodiments herein. First, the distance between the field plate 150 and the gate 130 may be increased by the additional thickness added by the interlayer dielectric material 145 disposed over the dielectric material 142 and the gate 130. Second, the interlayer dielectric material 145 may be chosen to have a lower dielectric constant than the dielectric material 142, further reducing unwanted additional C_{GS}.

It will be appreciated that the portions of the gate 130 and the field plate 150 that are closest to channel region 110 will tend to significantly influence the operating characteristics of the transistor 100. This will be particularly true if, as in one or more embodiments, the passivation material 115 is relatively thin compared to the dielectric materials 140, 142 and/or if the passivation material 115 has a relatively high dielectric constant compared to the dielectric materials 140, 142, and 145. In such embodiments, it will be appreciated that characteristics of the transistor 100 such as C_{GS}, C_{DS}, and source-drain breakdown voltage (as non-limiting examples) will depend upon the relative positioning of gate 130 and the field plate 150, particularly the center-to-center distance between the first end 132 of the gate 130 within the aperture 135 and the first end 152 of the field plate 150 within the aperture 155.

In one or more embodiments, the passivation material 115 is an aluminum oxide material with a thickness in a range between 20 and 5,000 Ångströms. In or more embodiments the passivation material 115 has a thickness in a range between 50 and 1000 Ångströms. In one or more embodiments, the dielectric material 140 is a silicon nitride with a thickness in a range between 100 and 2000 Ångströms, although other ranges may be used in one or more other embodiments. In one or more embodiments, the dielectric material 142 has a thickness in a range between 50 and 2000 Ångströms, although other ranges may be used in one or more other embodiments. In one or more embodiments, the interlayer dielectric material 145 is silicon oxide or silicon nitride with a thickness in a range between 20 and 10,000 Ångströms.

Although the thickness ranges above are given as examples, it will be appreciated that other ranges are suitable for use in one or more embodiments. It will be further understood that the choices of materials and thicknesses for various dielectrics may be expressed in terms of an equivalent oxide thickness ("EOT," i.e., the thickness of SiO₂ required to produce the same capacitance in a capacitor structure when a different dielectric is used). For instance, a layer of SiO₂ with a relative dielectric constant of 3.8 may be used as a reference. As an illustration, a 10nm-thick layer of SiO₂ may be said to have an EOT of 10nm while a 10nm-thick layer of Si₃N₄ with a relative dielectric constant of 9.5 would have an EOT of only 4 nm as a result of the higher electric permeability of the Si₃N₄ material.

In one or more embodiments, a transistor such as the transistor 100 is a gallium-nitride (GaN) based HEMT. In one or more embodiments such embodiments, a 2DEG is formed at an interface between a GaN layer and an aluminum doped layer with a stochiometric composition described by the chemical formula AlₓGa₁₋ₓN or AlₓIn₍₁₋ₓ₎N where x is between zero and one. In such embodiments it will be understood that the effective channel may be buried within the channel region 110 and may not extend to the top surface 112 of the channel region 110. In one or more embodiments, the passivation material 115 may be a material that provides surface passivation for the channel region 110 (e.g., by mitigating the influence of unwanted available electron energy states arising from dangling bonds at the top surface 112 of the substrate 102).

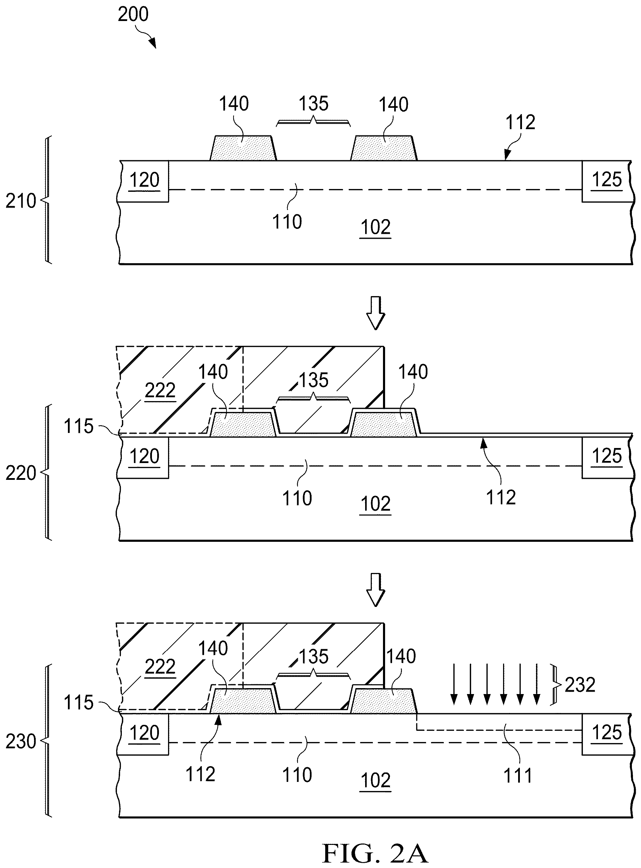

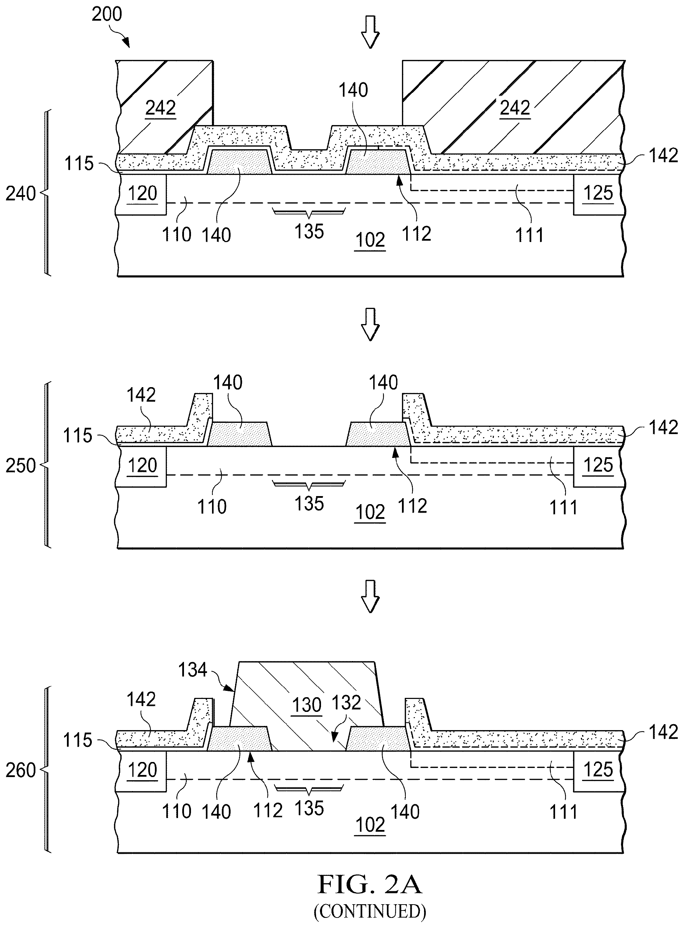

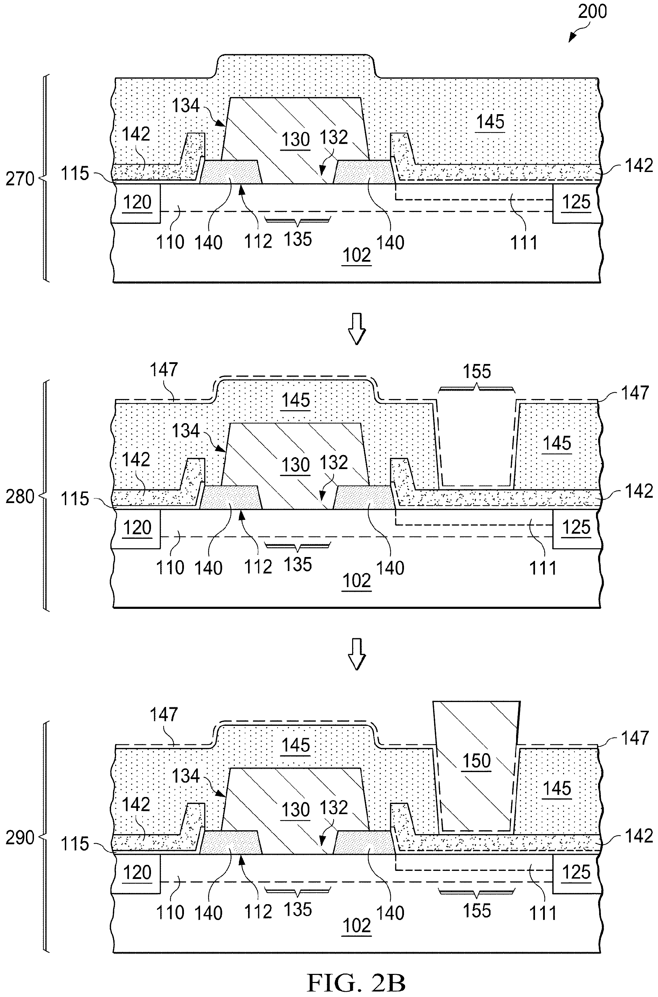

Along these lines, the channel region 110 is shown with a region 111 between the gate 130 and the current terminal 125 that is hatched to indicate a portion of the channel region 110 with modified electrical properties. As will be explained further below in connection with FIG. 2A and FIG. 2B, electrical conductivity of the channel region can be modified by selectively applying a surface treatment to the top surface 112 of the substrate. Such surface treatment can affect the properties of a 2DEG (or 2DHG) formed at buried heterojunction by various mechanisms including, but not limited to, decreasing charge trapping at the top surface 112, and/or increase the 2DEG conductivity at and/or below the 111 region.

As will be explained further, transistors such as the transistor 100 can be fabricated using processes that protect surfaces that are important to device performance from processing steps that may damage those surfaces or otherwise alter them in undesired ways. As indicated above, and described further below such processes can also be used to intentionally alter portions of such surfaces. In addition, in some such processes it is desirable to alter a particular portion of a surface and then perform additional processing steps that ensure the desired surface alteration can be preserved during further processing. For instance, it can be desirable to enhance conductivity of the channel region 110 when a transistor such as the transistor 100 is in an on state in which a conductive path is formed in the channel region 110 between the current terminals 120, 125. Notably, the transistor 100 and other transistors according to embodiments herein can be fabricated using processes (one example of which is the process 200 below) in which the location of areas subject to surface modification are self-aligned to the position of a gate electrode, a field plate or a similar structure (i.e., the process step or steps defining the final location of one or more structures or features also simultaneously defines the final location of the modified area and the distance between those elements, even if the structures or features themselves are formed or completed at different times).

Increasing the conductivity of the channel region 110 can result in higher maximum drain current densities which can provide better power handling in power devices such as RF switches and amplifiers and can also reduce parasitic resistance in areas where electrical contact is made to the device (e.g., source and drain connections). However, increasing channel conductivity can lead to increased gate leakage. Thus, it can be desirable to selectively enhance the channel conductivity between the gate 130 and a current terminal operated as the drain (e.g., the current terminal 125) while leaving the channel region 110 unmodified beneath the gate 130 or in the immediate vicinity of the gate 130. However, this level of control can be difficult or impossible using conventional transistor designs and process flows. A modified surface may also reduce charge trapping at the surface (e.g., in GaN heterostructures), which can result in devices that exhibit improved performance (e.g., higher operating power density).

FIG. 2A and FIG. 2B illustrate example steps in an example process 200 for fabricating transistors with field plates according to embodiments herein. The process 200 is described below in connection with fabrication of the transistor 100 of FIG. 1. The process 200 enables selective modification of the of the channel region 110 in the region 111 while protecting the channel region underneath the gate 130.

The process 200 includes steps 210, 220, 230, 240, 250, 260, 270, 280, and 290 which are depicted being performed to fabricate the transistor 100 of FIG. 1 on the substrate 102. As described below, the process 200 may confer certain advantages by allowing the relative positioning of the aperture 135 (and thus the eventual positioning of the gate 130) and region 111 that is subject to surface modification to be determined at the same time by a single patterning step (e.g., by a single photolithographic exposure) even though the gate 130 may be formed at a later time.

As above, the Figures, including FIG. 2 are not necessarily to scale. It will therefore be appreciated that certain elements of the process 200 as depicted in FIG. 2 and other processes depicted in subsequent figures may omit certain details of relative dimensions and geometries of various elements. It will also be understood that well-known parts of the process 200 such as photolithographic patterning steps (as one nonlimiting example) may not be shown for clarity and that a series of multiple process steps may be described as a single step for clarity.

At the outset of the process 200, the substrate 102 may already be provided with channel region 110 and other structures such as the current terminals 120,125 as described in connection with FIG. 1 already formed. At step 210, the dielectric material 140 is patterned on the top surface 112 of the substrate 102, defining the location of the aperture 135. The dielectric material 140 can be patterned by any suitable methods including, but not limited to, a subtractive process that includes deposition of a blanket film following by photolithographic patterning and etching to remove unwanted material from the top surface 112. Other processes can also be used such as additive processes which include photolithographic patterning of a resist that acts as a mask for deposition of the dielectric material 140, followed by a lift-off process to remove unwanted material that is not deposited directly on the top surface 112 of the substrate 102.

The sidewalls of the aperture 135 defined by the dielectric material 140 can have any suitable profile. As nonlimiting examples, the sidewalls of the aperture 135 may be sloped as shown or they may be vertical. It will be appreciated that the sidewall profile of the aperture and other related structures can be controlled by the choice of etching process and parameters of the process. For instance, an isotropic etching process may be used, or an anisotropic etching process may be used.

As shown, at step 220, the passivation material 115 has been deposited or otherwise formed over the exposed portions of the top surface 112 and the patterned dielectric material 140. The passivation material 115 and the dielectric material 140 and/or relative thicknesses of these materials may be chosen such that the passivation material 115 can be removed by a suitably selective etching process that does not etch the dielectric material 140 or the substrate 102. For example, in one or more embodiments the passivation material 115 is an aluminum oxide. In one or more such embodiments, the passivation material is deposited by a process that produces a conformal layer with a thickness in a range from 10 to 400 Ångströms including atomic layer deposition (ALD) as a nonlimiting example. Afterward, a photoresist or any other suitable masking material 222 is deposited above the passivation material 115 and patterned as shown.

At step 230, the passivation material 115 is patterned to selectively remove the passivation material 115 above the region 111. A surface modification process 232 is performed on the newly-exposed portion of the top surface 112 to enhance the conductivity of the channel region 110 during operation of the transistor 100 and/or modify the surface properties of the GaN surface above the region 111. The surface treatment process can be any of a number of suitable processes, including wet chemical surface treatments, plasma-based surface treatments, thermal annealing in a controlled gas atmosphere, ion bombardment, or controlled etching to thin the top surface 112 (e.g., via atomic layer etching or another suitable process) as nonlimiting examples or any suitable combination of such processes. During the surface modification process 232, other portions of the top surface 112 are protected from modification by the remaining passivation material 115 and the dielectric material 140In one or more embodiments, the masking material 222 is removed before the performing the surface modification process 232.In one or more embodiments, the passivation material 115 is also partially removed near the current terminal 120, allowing the surface modification process 232 to be used to modify the channel region 110 near the current terminal 120 in addition to the region 111. It will be appreciated that because the dielectric material 140 is patterned before deposition of the passivation material 115 in the process 200, a coarse lithography process can be used to define openings in which the passivation material 115 is removed, with any exposed portions of the dielectric material acting as a hard mask that precisely defines the positioning of the modified region(s).

At step 240, the dielectric material 142 is deposited or otherwise formed on the top surface 112. It will be appreciated that, in one or more embodiments, additional passivation material 115 can be deposited or otherwise formed before the dielectric material 142as indicated by the dashed portion of the passivation material 115 shown at step 240, above the region 111). The additional passivation material 115 can serve to prevent alteration of the modified surface due to oxidation or other environmental processes and can protect the modified properties of the portion of the top surface 112 above the region 111 during subsequent process steps which might otherwise damage the modified electrical properties of the region 111 within the channel region 110. Following deposition of the dielectric material 142, a masking material 242 is patterned as shown to expose the dielectric material 142 above the aperture 135. In one or more embodiments, depositing or redepositing a passivation material such as the passivation material 115 on exposed portions of a top surface of a channel region such as the top surface 112 of the channel region 110 can also enhance (or further) enhance electrical conductivity of the channel region beneath the interface between the channel region and the (re)deposited passivation material.

At step 250, the dielectric material 142 is selectively removed above the aperture 135 exposing the passivation material 115. The thickness and composition of the dielectric material 142 can be chosen such that it can be removed using a selective etching process that etches the dielectric material 142 preferentially over the passivation material 115 which can behave as an etch-stop. This allows the relatively thick dielectric material 142 (e.g., in one or more embodiments the dielectric material 142 or a similar material has a thickness between 50 and 2000 Ångströms, inclusive) to be etched using processes such as sputter etching or reactive ion etching which might damage the top surface 112 if it were not protected by the passivation material 115. Meanwhile, the relatively thin passivation material 115 can be quickly removed by a suitable wet chemical etch which will not damage the top surface 112 once it is exposed.

At step 260, the exposed passivation material 115 is removed using a suitable etching process. As one nonlimiting example, aluminum oxides can be removed using a buffered oxide etch (BOE). The gate 130 can then be formed immediately after removal of the passivation material 115 in the aperture 135 to minimize exposure of the top surface 112 underneath the gate 130 to environmental factors (e.g., oxygen) prior to formation of the gate 130. The gate 130 can be formed using any suitable processes including lithographic patterning followed by deposition of any suitable metals (e.g., gold, nickel, titanium nitride, titanium tungsten, and any suitable combinations or alloys thereof).

As shown, the positioning and dimensions of the patterned dielectric material 142 can define the shape of the gate 130, including relative widths of the first end 132 and the second end 134 of the gate 130. As an example, in one or more embodiments a gate such as the gate 130 does not have to have the "T-shaped" or "mushroom-shaped" profile pictured. As will be appreciated from further description below, the dielectric material 142 can also be used to define the positioning of the field plate 150 which is formed as described in connection with steps 270, 280, and 290 depicted in FIG. 2B.

At step 270, the interlayer dielectric material 145 is deposited over the substrate 102 including the gate 130. The interlayer dielectric material 145 can be any suitable dielectric including, as nonlimiting examples, silicon oxides, silicon nitrites, or the like. In some applications, a thickness between 500 and 5000 Ångströms will be desirable, but any suitable thickness can be used.

At step 280, the interlayer dielectric material 145 is etched to define the aperture 155 for the field plate 150. Optionally, additional passivation material 147 may be deposited over the interlayer dielectric material 145 as shown, followed by formation of the field plate 150 within the aperture 155 as shown in step 290. The field plate 150 may be formed using any suitable processes including lithographic patterning followed by metal deposition using sputtering, thermal evaporation, and the like, as nonlimiting examples. If a\additional passivation material 115 was formed at step 240, it can be used an etch stop for an etch process that selectively etches the interlayer dielectric material 145 and the dielectric material 142. If desired, any additional passivation material 115 remaining in the aperture after etching the interlayer dielectric material 145 can be removed by a wet etch, followed by deposition of the further passivation material 147 in order to provide a pristine surface prior to formation of the field plate 150. In one or more embodiments, an aperture such as the aperture 155 extends through both the interlayer dielectric material 145 and all or part of the dielectric material 142. For example, in the transistor 100, the dielectric material 142 is completely removed from the bottom of the aperture 155. In one or more such embodiments, additional dielectric material may be deposited in the aperture to achieve a desired distance between the first end 152 of the field plate 150 and the top surface 112 in the aperture 155.

In one or more embodiments, a passivation material such as the passivation material 115 is an aluminum oxide (e.g., Al₂O₃ or Al₂Oₓ, where x is a fractional number that is less than or greater than three. In one or more embodiments, a dielectric material such as the dielectric material 140 is a silicon nitride layer (e.g., SiN or SiNₓ, where x is a fractional number that is less than or greater than one. In one more embodiments, a dielectric material such as the dielectric material 142 is a silicon nitride layer (e.g., SiN or SiNₓ, where x is a fractional number that is less than or greater than one. In one or more embodiments, a dielectric material such as the interlayer dielectric material 145 is a silicon nitride layer (e.g., SiN or SiNₓ, where x is a fractional number that is less than or greater than one). If the passivation material 115 is an aluminum oxide material, a potassium hydroxide solution, buffered oxide etchant (BOE) solution, or tetramethylammonium hydroxide (TMAH) solution may be used to rapidly remove passivation material 115 without removing other dielectric materials such as silicon nitride.

It will be understood that it may be said that an etch "does not remove" a particular material when the etch rate with the respect to that material is zero or inappreciably slow relative to another material that is said to be preferentially etched or that an etch is selective when it preferentially removes one material at a faster rate than another material (e.g., if the etch rate for one material is at least twice as fast as the rate for the other material). BOE solution or dilute hydrofluoric acid are nonlimiting examples of suitable wet etches that are selective to aluminum oxide (or silicon oxide) over silicon nitride. It will be understood that other material combinations with suitable etches can be used as well. For instance, silicon nitride can be used as a passivation (or etch stop) material and silicon oxide used for other thicker dielectric layers or vice versa. As another example, silicon oxide can be used as a passivation (and/or an etch stop) material and aluminum oxide can be used for thicker dielectric layers.

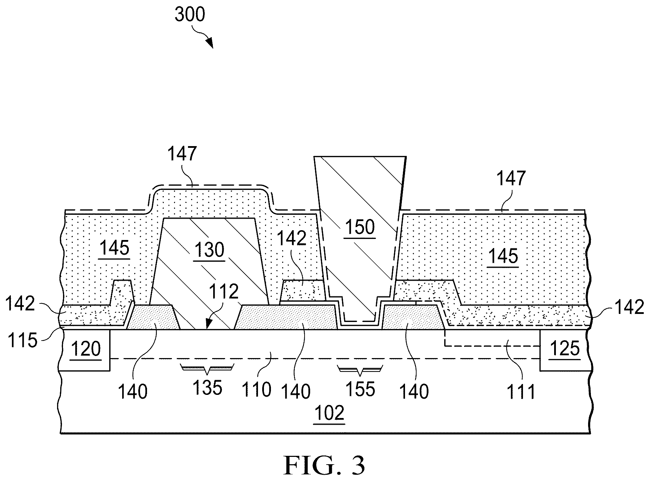

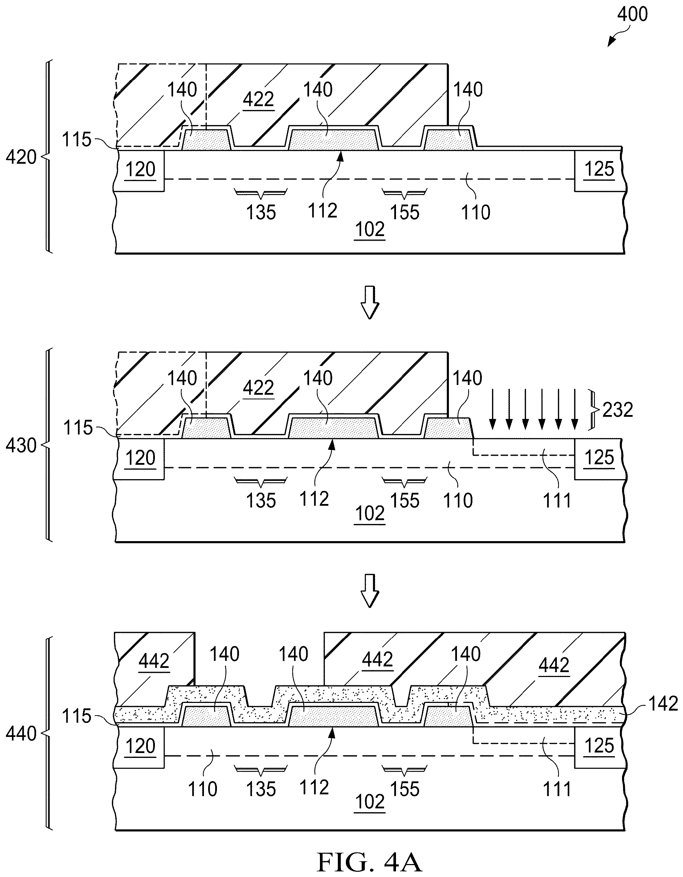

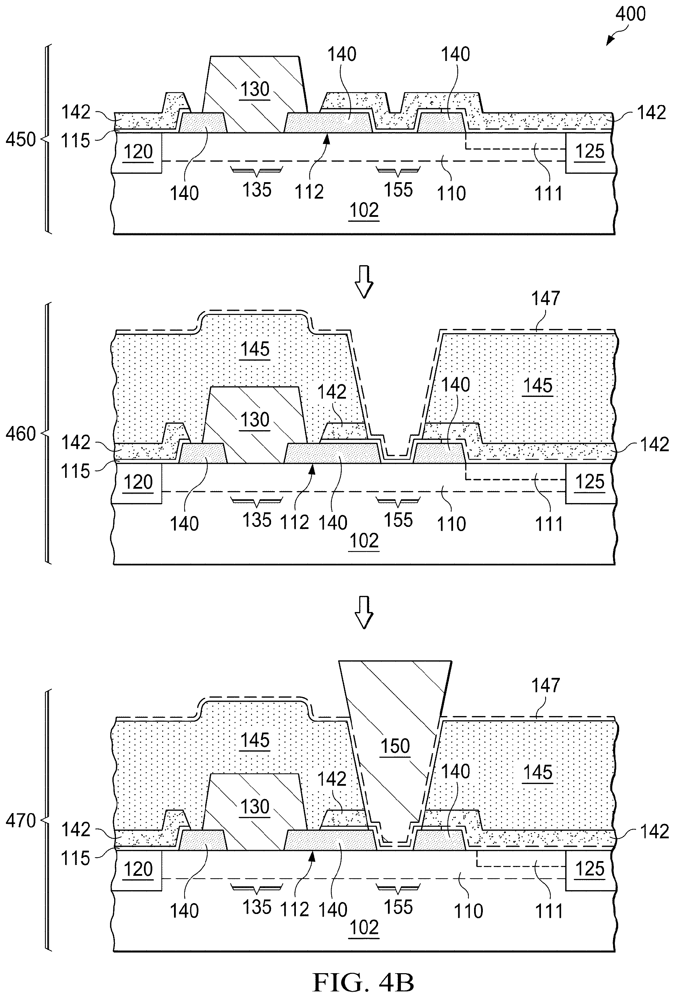

FIG. 3 is a schematic cross-sectional view of another example transistor according to one or more embodiments. The transistor 300 differs from the transistor 100 in the configuration of the aperture 155 for the field plate 150. Specifically, in the transistor 100 the aperture 155 passes through the passivation material 115 and the dielectric material 142, whereas in the transistor 300, the aperture 155 also passes through a portion of the dielectric material 140 that is not present in the transistor 100. As described further below in connection with FIG. 4A and 4B, the transistor 300 can be fabricated in a process in which the relative positioning and dimensions of the aperture 135 and location of the region 111 are defined in one lithographic process step (i.e., the aperture 135 in which the gate 130 is disposed is self-aligned to location of the region 111). In addition, in the process 400, the gate aperture 135 can also be self-aligned to the field plate aperture 155.

FIG. 4A and FIG. 4B illustrate steps in an example process 400 for fabricating a transistor according to one or more embodiments such as the transistor 100. The process 400 includes the steps 420, 430, and 440 shown in FIG. 4A which can be substituted for the steps 220, 230, and 240 of the process 200. The process 400 also includes the steps 450, 460, and 470 shown in FIG. 4B. As above and described further below, the process 400 may confer certain advantages by allowing the relative positioning of the aperture 135 and the aperture 155 to be determined at the same time by a single patterning step (e.g., by a single photolithographic exposure) even though the gate 130 and the field plate 150 may be formed in separate steps.

At step 420, the passivation material 115 is deposited or otherwise formed over the exposed portions of the top surface 112 and the dielectric material 140 which has previously been patterned analogously to the dielectric material 140 as shown in step 210 of the process 200. However, at step 320 the dielectric material 140 has been patterned to define the locations of both the aperture 135 and the aperture 155, resulting in three segments on the dielectric material 140 on the top surface 112 of the substrate 102 rather than the two segments seen in FIG. 2A. A photoresist or other masking material 422 is deposited and patterned as shown to define the region(s) where the passivation material 115 will be removed as described below in connection with step 430. In one or more embodiments, the dashed portion of the masking material 422 is also removed to allow removal of the passivation material 115 near the current terminal 120 (e.g., as described in connection with step 220 of the process 200 above).

At step 430, the passivation material 115 is patterned to selectively remove the passivation material 115 above the region 111. The surface modification process 232 is performed on the newly-exposed portion of the top surface 112 to enhance the conductivity of the channel region 110 during operation of the transistor 100. Because of the additional dielectric material 140 present at step 430 compared to step 230 of the process 200, the extent of the region 111 that is affected by the surface modification process 232 is smaller in the transistor 300 compared to the extent of the region 111 in the transistor 100. In one or more embodiments, a surface modification process such as the surface modification process 232 is not performed and a step such as the step 430 can be omitted. In one or more embodiments, additional passivation material 115 is deposited over the exposed portion of the dielectric material 140 and the region 111 after completion of the surface modification process 232.

At step 440, a spacer layer (dielectric material 142) is deposited or otherwise formed above the top surface 112 as shown. If additional passivation material 115 was deposited before formation of the spacer layer, the additional passivation material 115 can serve to prevent alteration of the modified surface due to oxidation or other environmental processes and can protect the modified properties of the portion of the top surface 112 above the region 111 during subsequent process steps which might otherwise damage the modified electrical properties of the region 111 within the channel region 110. In one or more embodiments in which the dielectric material is deposited directly on the top surface 112 above the region 111, the dielectric material can also provide similar protection of the of the electrical properties of the region 111. In one or more embodiments in which the passivation material 115 acts as an etch stop, the passivation material 115 can be removed via a suitable wet etch and then redeposited in order to mitigate any etch damage to the original layer of the passivation material 115

At step 450, the passivation material 115 and the dielectric material 140 are patterned followed by formation of the field plate 150 using substantially similar methods as those described in connection with steps 250 and 260 of the process 200.

At step 460 the interlayer dielectric material 145 is deposited over the substrate 102 including the gate 130 similarly to step 270 of the process 200, followed by etching the interlayer dielectric material 145, the dielectric material 142, and the dielectric material 140 as shown. In one or more embodiments, the passivation material at the bottom of the aperture 155 is then removed by a selective wet etch to expose the top surface 112 of the substrate 102. Additional passivation material 147 is deposited over the top surface 112 and the interlayer dielectric material 145, followed by formation of the field plate 150 at step 470. In one or more embodiments the additional passivation material 147 is deposited over the passivation material 115 that is left in place on the top surface 112 within the aperture 155.

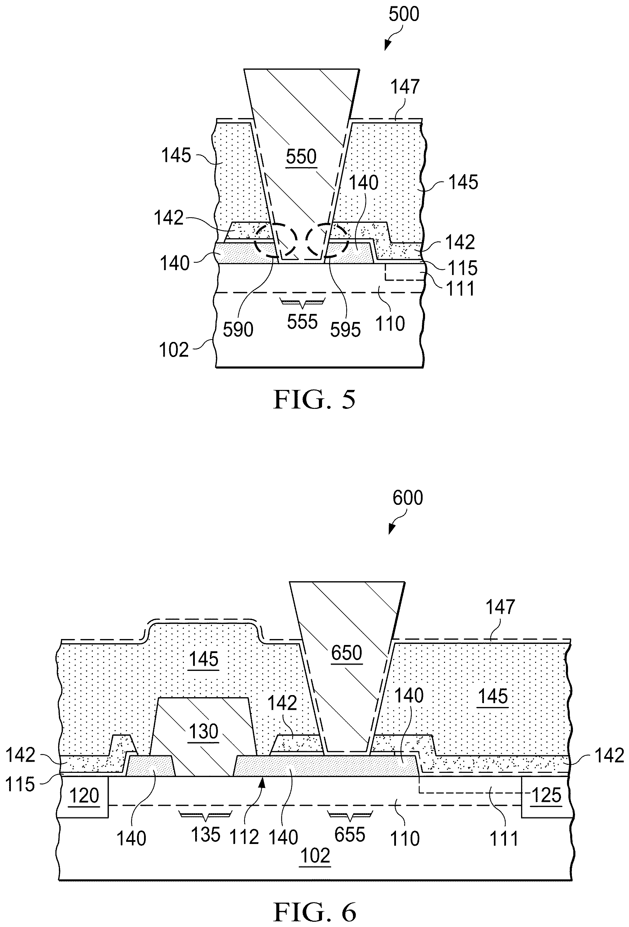

FIG. 5 is a cross-sectional schematic view of a transistor 500 with a field plate according to one or more embodiments which can be fabricated by modifying a process such as the process 400 to create an aperture related to the aperture 155 with one or more "steps" in the dielectric layers in the regions 590, 595 shown in FIG. 5. For instance, step 460 of the process 400 can be modified to remove a greater portion of the dielectric material 142 surrounding the aperture 555 than the dielectric material 140 to create a step or terrace in the region 590, the region 595, or both (see, for example, the terraced arrangement of the dielectric materials 140, 142 in FIG. 6). When fabricating the structure of FIG. 5 and related structures, the passivation material 115 can be used as an etch stop for an etching process that selectively removes the dielectric material 142. The overall dimensions of the aperture 555 can be chosen to achieve any desired result. For instance, it will be appreciated that the dimensions of the aperture 555, as well as the configuration of the field plate 550 can be adjusted to achieve a desired electric field distribution in the channel region 110 during operation of the transistor 500.

FIG. 6 is a cross-sectional schematic view of a transistor 600 with a field plate 650 which according to one or more embodiments which can be fabricated by modifying a process such as the process 200 or the process 400 to create an aperture related to the aperture 155 in which the field plate 650 is separated from the channel region 110 by both the dielectric material 140 and the passivation material 115. In contrast to the aperture 155, the aperture 655 is formed in the dielectric material 142 without passing through the dielectric material 140. Such an arrangement may be desirable in certain designs to achieve a desired trade-off between C_{DS} and C_{GD}, and electric field control in the channel region 110 resulting from the greater thickness of dielectric material between the field plate 650 and the channel region 110.

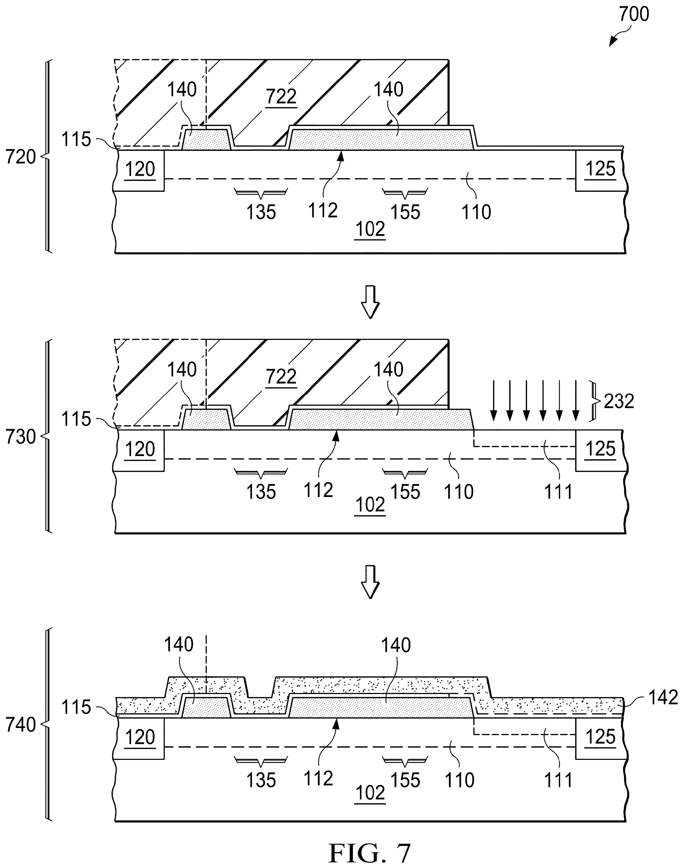

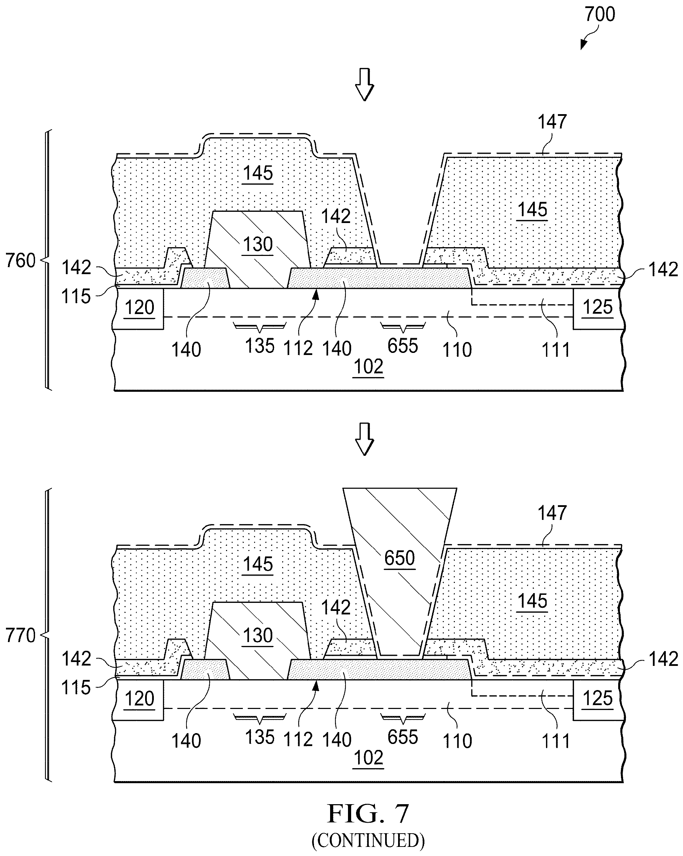

FIG. 7 is a flow diagram illustrating steps of a process 700 that is suitable for fabricating the transistor 600. It will be appreciated that steps which are substantially similar to steps described in connection with the process 200 or the process 400 are omitted for clarity. At step 720 (compare steps 210-220 of the process 200 or step 420 of the process 400), the dielectric material 140 and the passivation material 115 have been patterned as shown and a masking material 722 is then patterned over the structure. The masking material 722 to the left of the dashed line can be removed if desired to allow for surface treatment of a portion of the top surface 112 near the current terminal 120 in addition to the region 111 The relative width of the dielectric material 140 between the aperture 135 and the current terminal 125 is larger in the process 700 when compared with the process 200.

At step 730 (e.g., step 230 of the process 200 or step 430 of the process 400), the passivation material 115 is selectively removed above the region 111 as shown. If desired, the passivation material 115 can be removed above the current terminal 120 as well (if the masking material 722 is patterned at step 720 to expose the area indicated by the dashed boundary). The surface modification process 232 is performed on the newly-exposed portion of the top surface 112 to enhance the conductivity of the channel region 110 in the region 111 during operation of the transistor 600. The dielectric material 140 can act as a hard mask during the surface modification 232 that protects the channel region 110 outside the region 111 from modification. If desired, the masking material 722 can be left in place during step 730 and removed afterward.

At step 740, the passivation material 115 can be optionally removed and redeposited over the region 111 and the dielectric material 142 is deposited over the passivation material 115, followed by formation of the gate 130 as described in connection with steps 250 and 260 of the process 200.

At step 760 the aperture 655 is formed in the interlayer dielectric material 145, the dielectric material 142 and dielectric material 115, and at step 770, the field plate 650 is formed within the aperture 655. In one or more embodiments, as shown, the aperture 655 terminates at the passivation material 115. In one or more other embodiments, the passivation material 115 is removed at the bottom of the aperture 655 and the aperture 655 terminates at the dielectric material 140. In one or more other embodiments, the passivation material 115 is removed at the bottom of the aperture 655. Another dielectric material 147 is deposited and the aperture 655 terminates at the dielectric material 147.

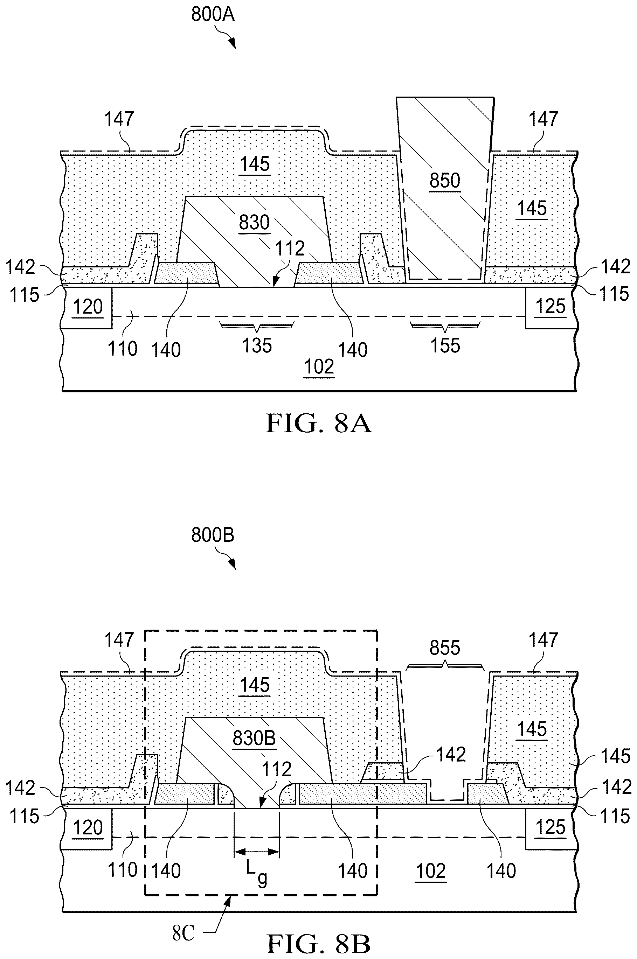

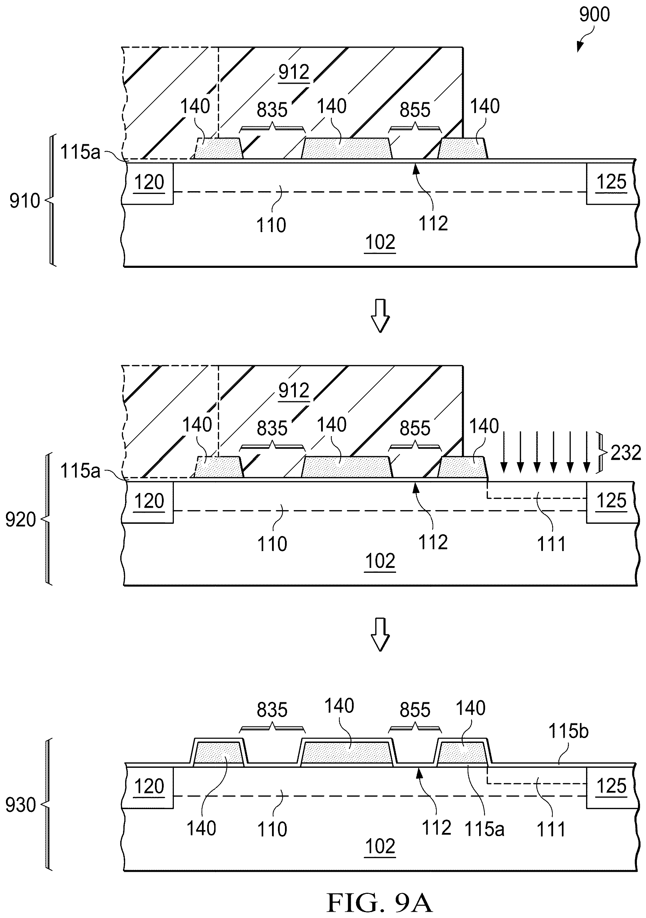

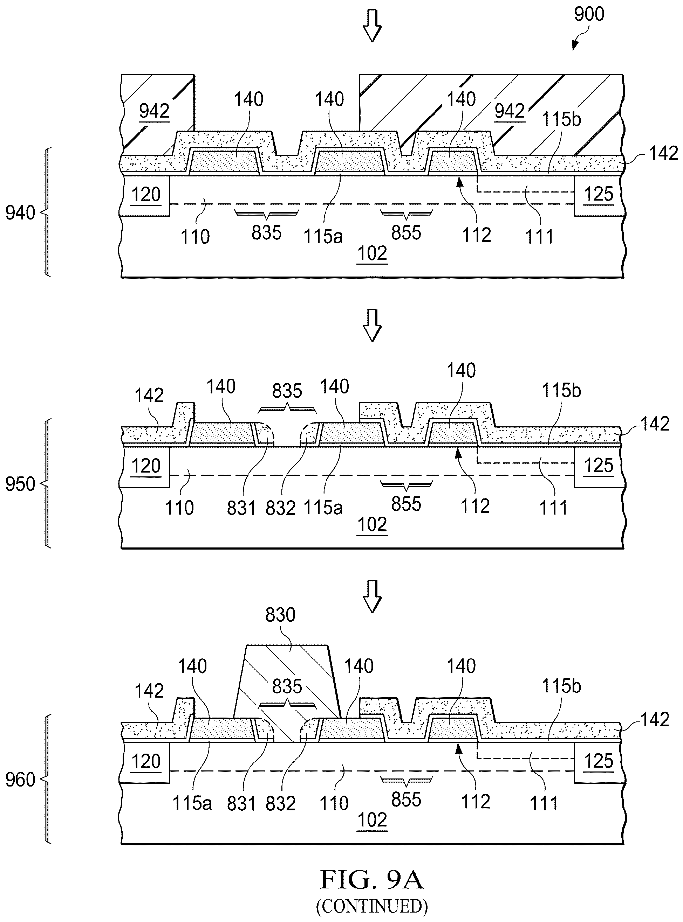

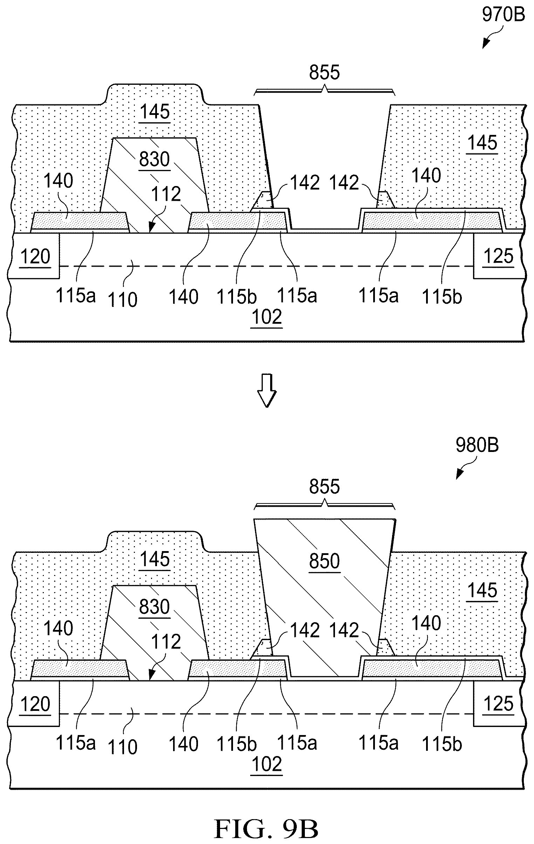

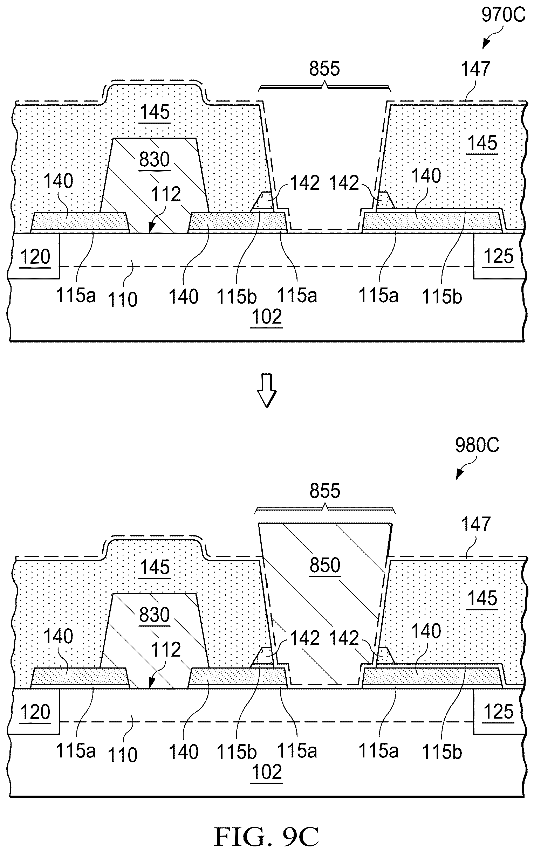

FIG. 8A shows another example transistor according to one or more embodiments. In the example transistor 800A the dielectric material 140 and the dielectric material 142 are both underlaid by the passivation material 115. The transistor 800 can be fabricated using techniques related to those described above in the processes 200 and 400, as described in further detail in connection with FIG. 9. Notably, as will be discussed further in connection with FIG. 9, the field plate 850 can rest directly on the passivation material 115 without requiring the top surface 112 above the channel region 110 beneath the field plate 850 to be exposed to the ambient environment. Such minimization of exposure of the top surface 112 of the substrate 102 underneath the field plate 150 can be desirable in certain applications, for example to reduce dry etch induced damage to the GaN surface. The dielectric material 115 that acting as etch stop can be optionally removed by wet etch and another dielectric material 147 can be deposited to sperate the field plate 850 from the top surface 112 to reduce damage to the original dielectric material 115 that may result from dry etching.

FIG. 8B shows another example transistor according to one or more embodiments. As in the example transistor 800A the dielectric material 140 and dielectric material are both underlaid by the passivation material 115 in the transistor 800B. Notably, in the transistor 800B, the aperture 855 is "terraced" as shown. As shown, the aperture 855 can also be lined by additional passivation material 147 which may be the same material or different from the passivation material 115. It will be appreciated that the relative dimensions of each step in the aperture 855 can be any suitable dimensions. For example, the relative width of the step on either side of the aperture 855 can be wider that the step on the opposite side in order to achieve a desired electric field distribution in the channel region 110 during operation of the transistor 800B.

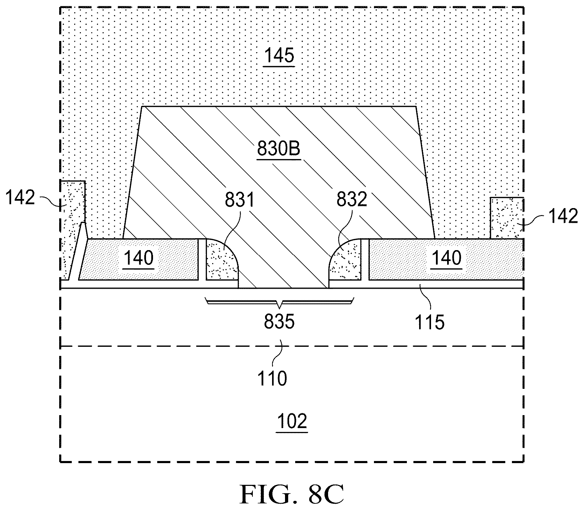

FIG. 8C shows the gate 830B of the transistor 800B in greater detail. In one or more embodiments, as shown, an aperture such as the aperture 835 includes spacers such as the spacers 831, 832. The spacers are formed from residual portions of the dielectric material 142. The presence or absence of such spacers and their relative dimensions if present can be controlled by varying process parameters during fabrication of a transistor such as the transistor 800A or the transistor 800B. Spacers can be useful to reduce the effective gate length ("L_{g}") that is determined by the length of the gate 830B that directly contacts the channel region 110 to achieve higher switching frequency during operation of the transistor 800B and other transistors according to embodiments herein. Processes that include spacers can be used to tune the geometry of the gate (e.g., the gate 830B) with a degree of dimensional precision that can be greater than the dimensional precision of the lithographic patterning processes used. It will be appreciated that spacers such as the spacers 831, 832 can also be incorporated into other transistors disclosed herein using processes such as the process 900 described further below in connection with FIG. 9A, FIG. 9B and other processes disclosed herein.

FIG. 9A, FIG. 9B, and FIG. 9C illustrate steps in an example process for fabricating a transistor according to one or more embodiments such as the transistor 800A or 800B. The process 900 includes the steps 910, 920, 930, 940, 950, and 960 shown in FIG. 9A and is described below with reference to fabrication of the transistor 800A. In one or more embodiments, the process 900 also includes the steps 970B and 980B as shown in FIG. 9B. In one or more embodiments, the process 900 includes the steps 970C and 980C as shown in FIG. 9B. Prior to the beginning of the process 900 the substrate 102 may be provided with a first layer of the passivation material 115 (a layer 115a) and the dielectric material 140 covering the top surface 112 of the substrate 102.

Prior to step 910, the dielectric material 140 has been patterned as shown by selectively removing the third dielectric material 140 using an appropriate etch process that does not remove the layer 115a of passivation material 115, defining the locations of the apertures 835 and 855 which will eventually define locations of the gate 830 and the field plate 850. The sidewalls of the dielectric material 140 may be sloped as shown, have a different slope, or may be vertical depending on choices for processing parameters chosen for the etching process(es) used. A masking material 912 (e.g., photoresist) is patterned above the layer 115a of passivation material 115 and the dielectric material 140 as shown, allowing the passivation material to be selectively removed above the region 111 using the dielectric material 140 as hard mask together with photoresist to protect other regions (e.g., the apertures 835 and 855) from being removed. The layer 115a of the passivation material 115 can also be removed near the current terminal 120 if desired, in which case the masking material 922 to the left of the dashed line is also removed.

At step 920, the masking material 912 can be left in place as shown or removed prior to performing the surface modification process 232. The surface modification process 232 is performed on the newly-exposed portion of the top surface 112 to enhance the conductivity of the channel region 110 during operation of the transistor 800A or 800B. If no surface modification is performed steps 920 and 930 can be omitted. Notably, dielectric material 140 can act as a hard mask that both defines the edge of the region 111 and protects the adjacent portion of the top surface 112 from the surface modification process 232. As a result, the exact location of the edge of the masking material 912 is not critical. In some applications this can be desirable because it can allow for greater tolerances in the lithographic processes used to pattern the masking material 912.

At step 930, the remaining exposed portions of the layer 115a of the passivation material 115 are removed from the top surface 112 and an additional layer 115b of the passivation material 115\ is deposited or otherwise formed on the top surface 112 and on the dielectric material 140. The additional passivation material 115 (the layer 115b) can serve to prevent alteration of the modified surface in the region 111 due to oxidation or other environmental processes and can protect the modified properties of the portion of the top surface 112 above the region 111 during subsequent process steps.

At step 940, the dielectric material 142 is deposited or otherwise formed over the dielectric material 140 and the passivation material 115b.

At step 950, the dielectric material 142 is selectively removed as shown via a suitable etching process, with the passivation material 115b acting as an etch stop, If a suitably anisotropic etch process is used, residual dielectric material 142 will remain along the sidewalls of the aperture 835 as indicated by the dashed lines within the aperture 835 (e.g., the spacers 831, 832 shown in FIG. 8C).

At step 960, the exposed portion of the layer 115b of passivation material 115in the aperture 835 is removed using a suitable etching process that does not damage the exposed top surface 112 in the aperture 835 (e.g., a wet etch that selectively removes the passivation material of the layer 115b without damaging the top surface 112 of the substrate 102), followed by formation of the gate 830 (or the gate 830B) within the aperture 835. The geometry of the gate 830 or 830B can vary and discussed above in connection with the gate 130.

FIG. 9B depicts steps 970B and 980B which are performed in one or more embodiments (e.g., after step 960 of the process 900). At step 970B, the interlayer dielectric material 145 is deposited over the gate 830 (or gate 830B) and the aperture 855 is exposed by selectively removing the interlayer dielectric material 145 and the dielectric material 142. The residual layer 115b of passivation material 115 remains on the top surface 112 within the aperture 855 and at step 980B, the field plate 850 is formed within the aperture 855.

FIG. 9C depicts steps 970C and 980C which are performed in one or more embodiments. At step 970C, the interlayer dielectric material 145 is deposited over the gate 830 (or gate 830B) and the aperture 855 is exposed by selectively removing the interlayer dielectric material 145 and the dielectric material 142. The residual portion of the layer 115b of passivation material 115 remains on the top surface 112 within the aperture 855 after step 960 of the process 900 is removed, followed by deposition of additional passivation material 147. The additional passivation material 147 (which can be the same material as the passivation material 115) lines the sidewalls of the aperture 855 and optionally overlays the interlayer dielectric material 145. At step 980C, the field plate 850 is formed within the aperture 855.

It will be appreciated that in one or more embodiments, the arrangement of the field plate 850 as shown in FIG. 9B or FIG. 9C be altered by using process steps disclosed above and/or related process steps. For instance, if the dielectric material 140 is patterned differently than at step 910 (e.g., compare the arrangement of the dielectric material 140 at step 720 of the process 700), the aperture 855 can be defined in the dielectric material 142 rather than the dielectric material 140, resulting in the lower end of the field pate 850 resting on top of the dielectric material 140 (see, for example the arrangement of the field plate 650 in FIG. 6 and at step 770 in FIG. 7).

Alternatively, it will be appreciated that, in one or more embodiments, a related arrangement of the field plate 850 can also be achieved by varying the width of the dielectric material 140 and adjusting positioning of the masking material 942 at step 940 to leave an area where the dielectric material 142 remains over a sufficiently wide portion of the dielectric material 140. In such embodiments, an aperture for the field plate can be formed in a portion of the dielectric material 142 that is disposed above an uninterrupted segment of the dielectric material 140.

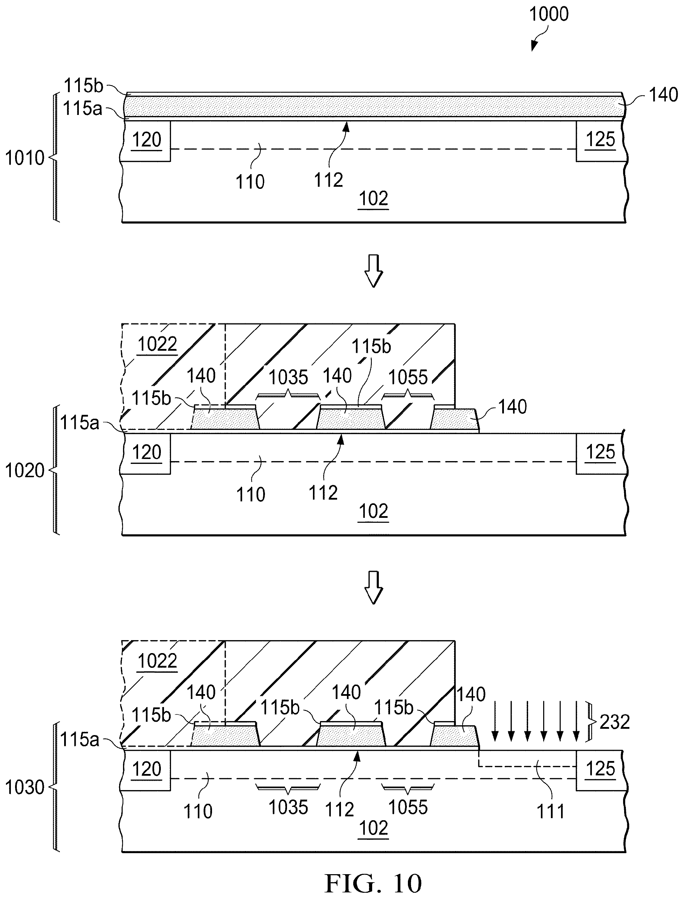

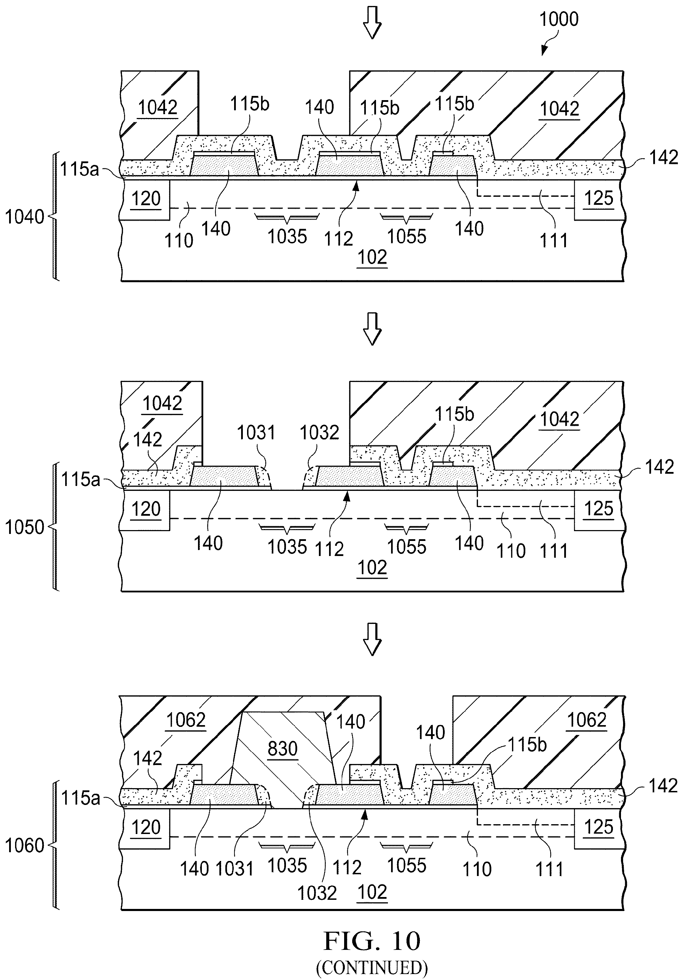

FIG. 10 depicts an alternative process 1000 which is related to the process 900. One difference between the process 1000 and the process 900 can be seen at step 1010 where a three-layer dielectric stack is formed on the substrate 102. The stack includes two layers of the passivation material 115: a first layer 115a directly on the top surface 112 of the substrate 102 separated from a second layer 115b by an interposing layer of the dielectric material 140.

Step 1020 can be performed analogously to step 910 of the process 900. At step 1020, the layer 115b of the passivation material 115 can be patterned as an etch mask for the material 140 with a selective etch that preferentially removes the passivation material 115 followed by etching the dielectric material 140 using an etch that preferentially removes the dielectric material 140, with the first layer 115a of the passivation material 115 acting as an etch stop. The resulting structure defines the location of the apertures 1035 and 1055 which can be used for formation of a gate (e.g., a gate 130, or 830) and a field plate (e.g., a field plate 150, field plate 550, field plate 650, or field plate 850).

At step 1030, the layer 115a of the passivation material 115 is patterned to selectively remove the passivation material 115 above the region 111 using a combination of patterned photoresist and material 140 as hard mask. The surface modification process 232 is performed on the newly-exposed portion of the top surface 112 to enhance the conductivity of the channel region 110 during operation of the transistor 800A or 800B. If no surface modification is performed steps 1030 and 1040 can be omitted.

At step 1040, the dielectric material 142 is deposited or otherwise formed over the dielectric material 140 the two layers of passivation material 115 (the layers 115a, 115b) as shown and a masking material 1042 (e.g., photoresist) is formed as shown

At step 1050, the dielectric material 142 is selectively removed as shown via a suitable etching process, with the passivation material 115 (the layer 115b) acting as an etch stop. If a suitably anisotropic etch process is used, residual dielectric material 142 will remain along the sidewalls of the aperture 1035 as indicated by the dashed lines within the aperture 1035 (the spacers 1031, 1032; e.g., the spacers 831, 832 shown in FIG. 8C). The exposed passivation material 115 is removed using a suitable etching process that does not damage the exposed top surface 112 in the aperture 835 (e.g., a wet etch that selectively removes the passivation material 115 without damaging the top surface 112 of the substrate 102).

At step 1060, the gate 830 (or the gate 830B) is formed within the aperture 835. The geometry of the gate 830 or 830B can vary and discussed above in connection with the gate 130. A field plate can be fabricated by performing steps similar to those described above in connection with other processes in which an interlayer dielectric material such as the interlayer dielectric material 145 is formed over the gate and the area surrounding the aperture 1055 and then patterned to allow formation of the field plate in the aperture 1055.

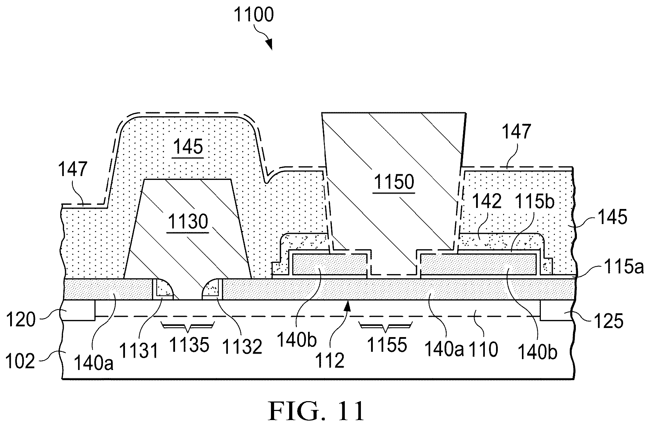

FIG. 11 is a cross-sectional view of another example transistor according to one or more embodiments. The transistor 1100 includes structures with tunable geometries for a gate and field plate which can be fabricated in a process in which the critical dielectric structures are formed and patterned before formation of the gate and field plate, thereby avoiding potential damage or performance degradation that could during high temperature dielectric formation processes if the gate and field plate were formed in earlier process steps. Specifically, the transistor 1100 includes a first layer 140a of the dielectric material 140 and a second layer 140b of the dielectric material 140, separated by a thin layer 115a of the passivation material 115. The dielectric material 142 overlies the second layer 140b of the dielectric material 140, with a second layer 115b of the passivation material 115 interposed between the second layer 140b of the dielectric material 140 and the dielectric material 142.

The gate 1130 is formed within the aperture 1135 in the first layer 140a of the dielectric material 140. As shown, gate spacers 1131 and 1132 (e.g., spacers 831, 832) can be included within the gate aperture 1135 as shown or they can be omitted. The field plate 1150 is formed in the aperture 1155 in the second layer 140b of the dielectric material 140, allowing the field plate 1150 to be disposed a controlled distance above the top surface 112 of the substrate 102 in the channel region 110. The field plate 1150 can have a stepped profile as shown with portions resting on the second layer 140b of the dielectric material 140 to either side of the aperture 1155. Alternatively additional passivation material 147 may line the aperture 1155 and overlay the interlayer dielectric material 145 as indicated by the dashed regions immediately surrounding the field plate 1150.

It will be appreciated that, in the transistor 1100 and other transistors described herein, the apertures 1135 and 1155 as well as surrounding dielectric structures can have any suitable sidewall profiles. For instance, any of the sidewalls pictured may be vertical or inclined with any suitable slope depending on processing parameters chosen during fabrication of the transistor 1100. Similarly, the gate 1130 and the field plate 1150 may have any suitable shapes.

In one or more embodiments, the dashed portions of the first layer 115a of the passivation material 115 and the second layer 115b of the passivation material 115 are absent. In such embodiments, the portion of the field plate 1150 closest to the top surface 112 of the substrate 102 in the aperture 1155 directly contacts the first layer 140a of the dielectric material 140. Such a configuration can be desirable in certain applications to reduce charge trapping within the passivation material 115 or on surfaces of the passivation material 115 in the vicinity of the field plate 1150.

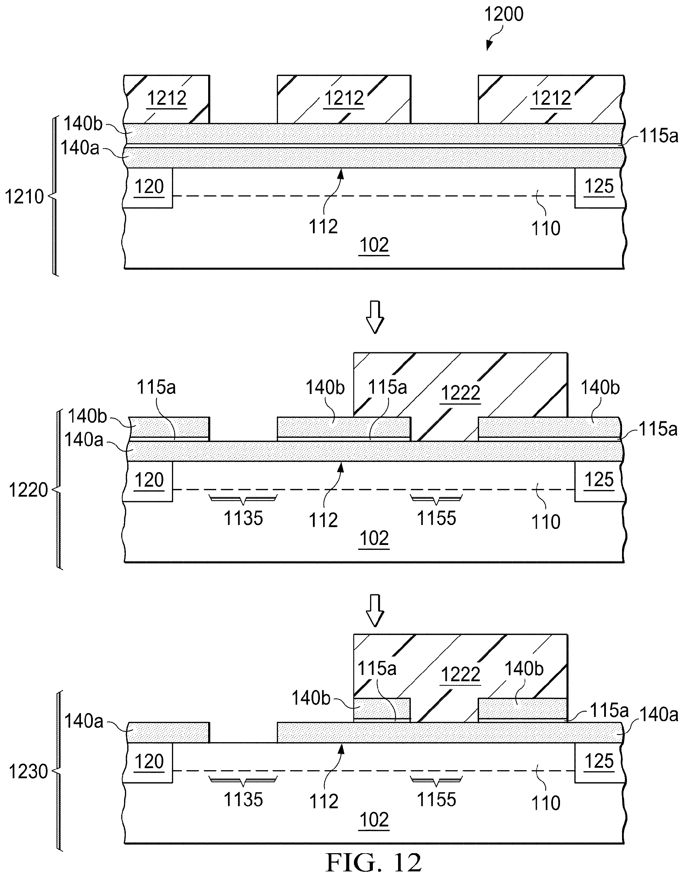

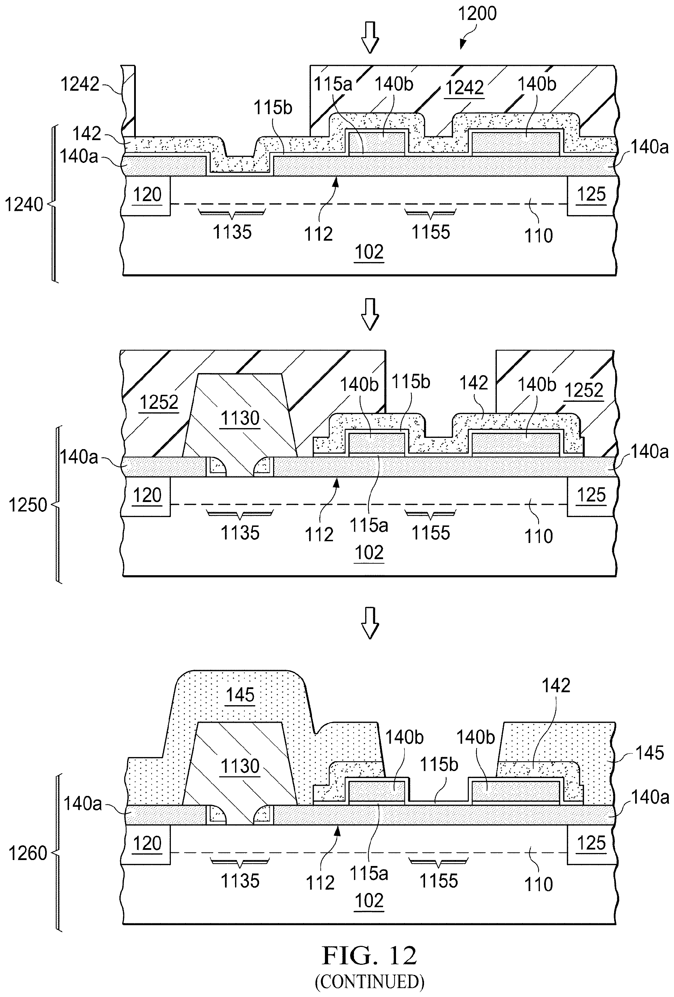

FIG. 12 is a flow diagram showing illustrating steps an example process suitable for fabricating a transistor such as the transistor 1100 and related transistors according to one or more embodiments. The process 1200 includes the steps 1210, 1220, 1230, 1240, 1250, and 1260 which are described below in connection with fabrication of the transistor 1100 of FIG. 11. As with other processes described above, the process 1200 is one in which a gate (e.g., the gate 1130) and a field plate (e.g., a field plate) 1350 are self-aligned to each during a patterning step that precedes formation of both the gate and the field plate.

At step 1210, the substrate 102 is provided with the dielectric stack shown disposed on the top surface 112 above the channel region 110. The first layer 140a of the dielectric material 140 is disposed directly on the top surface 112 followed by a layer of passivation material 115 (the first layer 155a of passivation material 115) and the second layer 140b of the dielectric material 140 directly above the layer 115a of passivation material 115. It will be understood that in one or more embodiments, the first layer 140a of the dielectric material 140 and the second layer 140b of the dielectric material 140 are the same material but may have different thicknesses. In one or more other embodiments, a different material from the dielectric material 140 can be substituted for the first layer 140a or the second layer 140b of the dielectric material 140. A masking material 1212 (e.g., photoresist) is patterned above the second layer 140b of the dielectric material 140 as shown.

At Step 1220, the second layer 140b of the dielectric material 140 has been patterned as shown, to define the locations of the apertures 1135 in the aperture 1155, and the layer 115a of passivation material 115 is removed from above the exposed portions of the first layer 140a of the dielectric material 140 using any suitable processes, included those described above in connection with related processes. The layer 115a of passivation material 115 can act as an etch stop (i.e., a hard mask) for an etching process that removes the portions of the second layer 140b of dielectric material 140 shown. Subsequently the layer 115a of passivation material 115 can be removed by a selective etching process that can include a wet chemical etch or a dry plasma etch using the masking material 1212 as a mask for the etching process. Afterward, the masking material 1212 is removed and additional masking material 1222 (e.g., a photoresist which can be the same or different from the masking material 1212) is patterned above the structure as shown.

At step 1230, the dielectric stack is patterned further to make room for the gate 1130 which will be formed in the aperture 1135 during a subsequent step. Additional portions of the second layer 140b of the dielectric material 140 are removed, along with removing a portion of the first layer 140a of the dielectric material 140 to expose the top surface 112 at the bottom of the aperture 1135. Portions of the second layer 140b of the dielectric material 140 can also be removed as shown in between the aperture 1155 and the current terminal 125 (e.g., to make room for an electrode, not shown, that will contact the current terminal 125). Afterwards, portions of the layer 115a of the passivation material 115 can be removed using any suitable dry or wet etch processes using the masking material 1222 as an etch mask.

At step 1240, additional passivation material 115 (a layer 115b of passivation material 115) is deposited over the dielectric stack, as patterned at step 1230. followed by deposition of the dielectric material 142 over the passivation material 115b. It will be understood that, in one or more embodiments, a different material than the passivation material 115 as the passivation material 115b can be used.

At step 1250 the dielectric stack is further patterned to expose the top surface 112 of the substrate 102 in the aperture 1135, followed by formation of the gate 1130 in the aperture 1135. In one or more embodiments, the etching process used to selectively remove the dielectric material 142 is adjusted to leave residual dielectric material 142 in the aperture 1135, thereby forming gate spacers (e.g., the spacers 1131, 1132 of FIG. 11). Meanwhile, in one or more other embodiments the dielectric material 142 and passivation material 115 are removed completely from the top surface 112 of the substrate 102 in the aperture 1135 such there are no spacers present in the aperture 1135 surrounding the gate 1130. The passivation material 115 can be removed using a wet chemical etch to avoid plasma damage to the top surface 112 which might otherwise occur if a plasma etching process were used.

At step 1260, the interlayer dielectric material 145 is deposited over the gate 1130 and the remaining patterned dielectric material as shown, following by selective removal of the interlayer dielectric material 145 and the dielectric material 142 as shown. The passivation material 115 in the aperture 1155 can act as an etch stop as previously described. The layer 115b of passivation material 115 within the aperture 1155 may be subsequently removed by a wet etch process. In one or more embodiments, additional dielectric material (which can be the same as the passivation material 115b or a different material) is re-deposited over in the aperture 1155. Doing so can allow the distance between bottom of the field plate 1150 and the top surface 112 to be adjusted as desired The field plate 1150 can subsequently be formed in the aperture 1155 as described previously in connection with related processes.

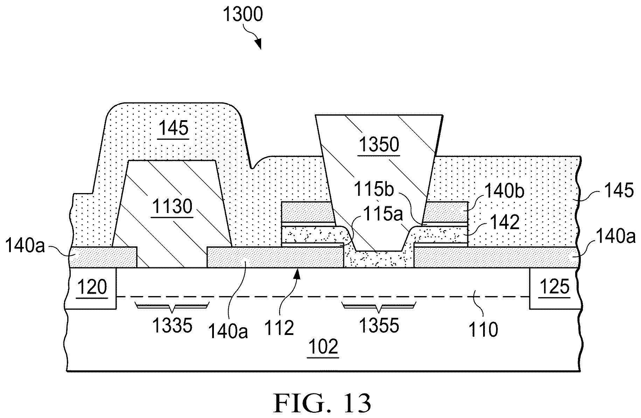

FIG. 13 is a cross-sectional view of another example transistor according to one or more embodiments. The transistor 1300 is related to the transistor 1100 and includes analogous structures with tunable geometries for a gate and field plate which can be fabricated in a process in which the critical dielectric structures are formed and patterned in a sequence which allows the top surface 112 above the channel region 110 to be protected from possible damage from high-temperature process steps. The transistor 1300 differs from the transistor 1100 in the dielectric stack surrounding the field plate. For example, the transistor 1300 includes a first layer 140a and a second layer 140b of the dielectric material 140 with a three-layer structure in between the two layers 140a, 140b. A first layer 115a of passivation material 115 is disposed directly on the first layer 140a of the dielectric material 140 and separated from a second layer 115b of the passivation material 115 by the dielectric material 142. The second layer 140b of the dielectric material 140 is disposed directly on the second layer 115b of the passivation material 115. In the aperture 1355, the field plate 1350 is separated from the top surface 112 of the substrate 102 by the dielectric material 142. The thickness of the dielectric material 142 can be chosen to achieve a particular electric field distribution in the channel region 110 during operation of the transistor 1300.

In the transistor 1300 and in related transistors the first layer 140a and the second layer 140b can have different thicknesses. Similarly, in the transistor 1300 and related transistors the layers 115a and 115b can have different thicknesses. It will also be understood that, in one or more embodiments, the layers 140a and 140b are made from different materials. Similarly, in one or more embodiments, the layers 115a and 115b are made from different materials.

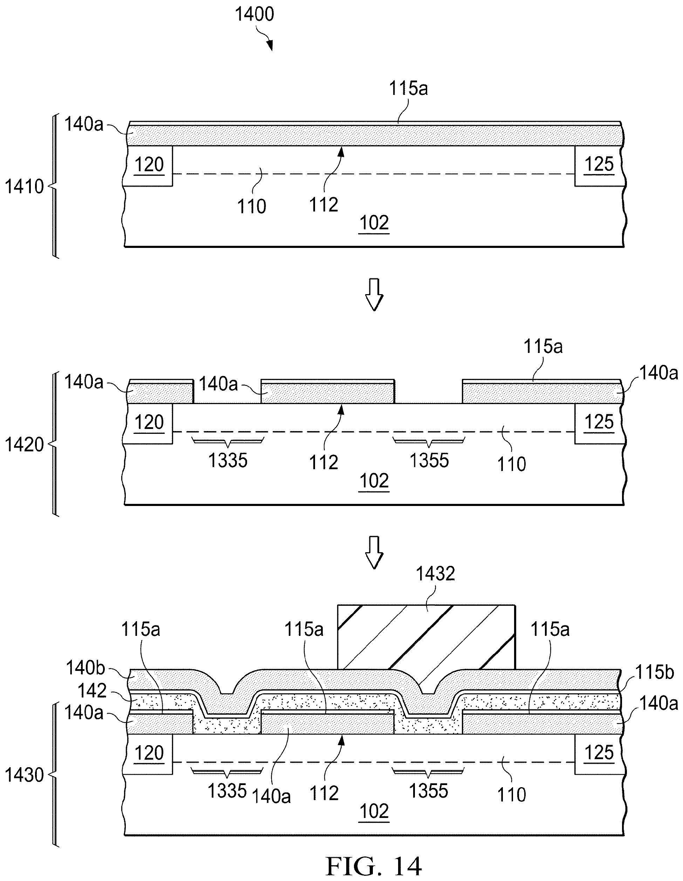

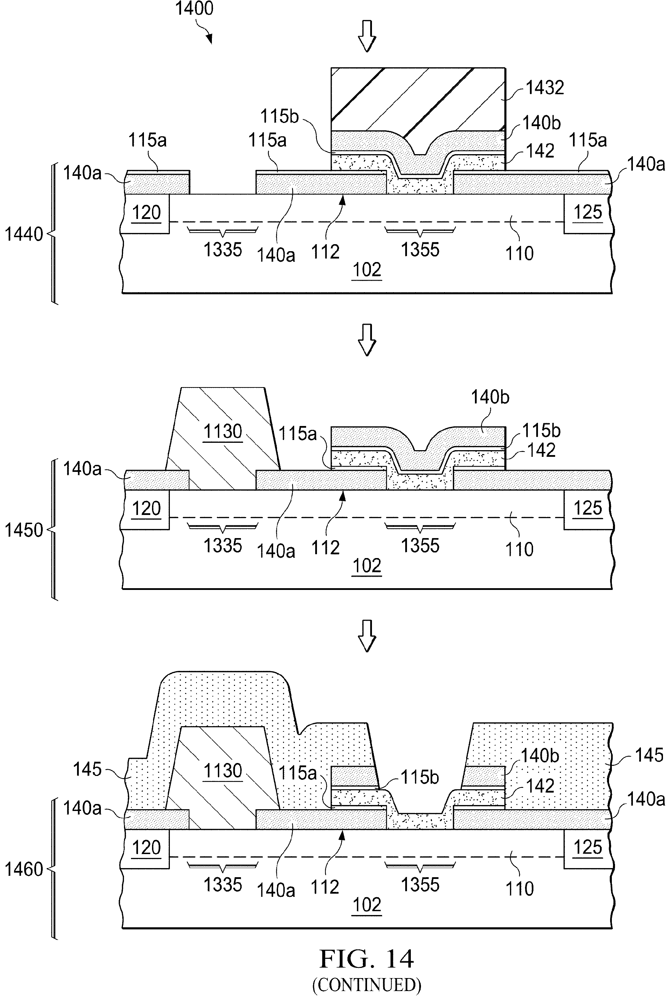

FIG. 14 is a flow diagram showing illustrating steps an example process suitable for fabricating a transistor such as the transistor 1300 and related transistors according to one or more embodiments. The process 1400 includes the steps 1410, 1420, 1430, 1440, 1450, and 1460 which are described below in connection with fabrication of the transistor 1300 of FIG. 13. As with other processes described above, the process 1400 is one in the gate 1330 and the field plate 1350 are self-aligned to each during a patterning step that precedes formation of both the gate 1330 and the field plate 1350.

At step 1410, the substrate 102 is provided with the dielectric stack shown disposed on the top surface 112 above the channel region 110. A first layer 140a of the dielectric material 140 is disposed directly on the top surface 112 followed by a first layer 115a of passivation material 115 disposed directly on the first layer 140a of the dielectric material 140.

At Step 1420, the first layer 140a of the dielectric material 140 is patterned as shown, to define the locations of the aperture 1335 and the aperture 1355. The layer 115a of the passivation material 115 is removed from above the exposed portions of the top surface 112 of the substrate 102 using any suitable processes, included those described above in connection with related processes. If the passivation material 115 is overetched, the underlying dielectric material 140 can have a sloped profile in the apertures 1335 and 1355 after the first layer 140a of the dielectric material 140 is appropriately etched (e.g., using an anisotropic etch). It will be understood that the relative dimensions of the different layers are exaggerated for clarity and that the etched sidewall profiles are not pictured in subsequent steps.

At step 1430, additional dielectric layers are deposited over the areas previously patterned at step 1420. The dielectric material 142 is deposited, followed by a second layer 115b of the passivation material 115, and then a second layer 140b of the dielectric material 140. A masking material 1432 (e.g., photoresist) is patterned as shown above the structure.

At step 1440, the dielectric stack is removed in the area surrounding the aperture 1335. Any suitable sequence of etching steps can be used to remove the second layer 140b of the dielectric material 140, the second layer 115b of the passivation material 115, and the dielectric material 142. For instance, these layers can be removed sequentially. As one nonlimiting example, the second layer 140b of the dielectric material 140 can be removed using a selective etch that stops at the second layer 115b of the passivation material 115. The dielectric material 142 can then be removed by a selective etch that stops at the first layer 115a of the passivation material 115. In one or more embodiments, as in related processing steps described above, spacers (not shown in FIG. 13 or FIG. 14) similar to the spacers 1131, 1132 shown in FIG. 11 can be formed in the aperture 1335 by controlling the etch used to pattern the dielectric material 142 (see, for example, the description of steps 1240 and 1250 of the process 1200, above).

At step 1450 the first layer 115a of the passivation material 115 is removed from the area surrounding the aperture 1335, followed by formation of the gate 1330 in the aperture 1335. At step 1460, the interlayer dielectric material 145 is deposited over the gate 1330 followed by selective removal of the interlayer dielectric material 145 as shown, and the second layer 140b the dielectric material with the second layer 115b of the passivation material 115 acting as an etch stop. The remaining passivation material 115 is removed from the aperture 1355 (e.g., using a suitable wet etch as described above), leaving the dielectric material 142 on the top surface 112 in the aperture 1355. The field plate 1350 can be formed subsequent to completion of the step 1460.

### EXAMPLES

Features of embodiments may be understood by way of one or more of the following examples:
Example 1: A device or method that includes a semiconductor substrate having a channel region operable as a transistor channel. The channel region extends between a first current terminal region at a first end of the channel region and a second current terminal region at a second end of the channel region. A first dielectric stack is disposed directly on a top surface of the channel region. The first dielectric stack includes a first dielectric layer and a first etch stop layer disposed directly on the first dielectric layer. The first dielectric stack is patterned to simultaneously form: a first opening in the first dielectric stack located between the first end of the channel region and the second end of the channel region and a second opening that passes through at least part of the first dielectric stack between the first opening and the second end of the channel region. A dielectric spacer layer is formed above the patterned first dielectric stack and within the first and second apertures.

The spacer layer is patterned to selectively remove the spacer layer above the first opening and an electrically conductive gate electrode is formed that directly contacts the top surface of the channel region in a gate aperture having a location defined by the first opening. An interlayer dielectric is formed above the gate electrode and is selectively removed to form a field plate aperture with a location defined by the second opening and an electrically-conductive field plate electrode is formed in the field plate aperture.

Example 2: The device or method of Example 1, that further includes a second dielectric stack formed directly on the spacer layer that includes a second etch stop layer and a second dielectric layer directly on the second etch stop layer. The second dielectric stack is patterned to form a patterned portion of the second dielectric stack that exposes the spacer layer in the first aperture by removing the second dielectric layer above the first opening using a first etch that does not remove the etch stop layer and removing the second etch stop layer with a second etch that does not remove the spacer layer. The spacer layer is patterned to expose the top surface of the channel region in the first opening using a third etch.

Example 3: The device or method of Example 1 or Example 2, where the first and second dielectric layers are formed from a silicon nitride material using low-pressure chemical vapor deposition (LPCVD) and where the first and second etch stop layers are formed from an aluminum oxide material.

Example 4: The device or method of any one of Examples 1-3, where the first etch stop layer, the second etch stop layer, or both the first and second etch stop layers are formed using atomic layer deposition (ALD).

Example 5: The device or method of any one of Examples 1-4, in which the patterned portion of the second dialectic stack above the second opening is protected from the first, second, and third etches. At least part of the patterned portion of the second dielectric stack above the second opening is selectively removed by: selective removal the second dielectric layer with a fourth etch that does not remove the second etch stop layer. The second etch stop layer is selectively removed with a fifth etch that does not remove the spacer layer. The first portion field plate electrode is disposed directly on the spacer layer in the field plate aperture above the second opening.

Example 6: The device or method of any one of Examples 1-5, where a width of the field plate aperture at the second dielectric layer is wider than a width of the second opening in the first dielectric layer and a center of the field plate aperture is offset from a center of the second opening.

Example 7: The device or method of any one of Examples 1-6, where the first dielectric stack further includes a third dielectric layer disposed directly on the first etch stop layer; and where patterning the first dielectric stack includes: patterning the third dielectric layer to form the first opening in the third dielectric layer using a first etch that does not remove the first etch stop layer; patterning the third dielectric layer to form the second opening in the third dielectric layer using the first etch; removing the first etch stop layer from the first and second openings using a second etch that does not remove the first dielectric layer; using a masking material to form a masked portion of the third dielectric layer surrounding the second opening; forming an exposed portion of the first dielectric layer by selectively removing the remaining third dielectric layer surrounding the masked portion of the third dielectric layer using third etch that does not remove the first etch stop layer; forming a first opening the first dielectric layer beneath the first opening in the third dielectric layer using a fourth etch that does not remove the top surface of the channel region; removing the first etch stop layer from the exposed portion of the first dielectric layer using a fifth etch that does not remove the first dielectric layer.

Example 8: The device or method of any one of Examples 1-7, further includes: forming a second etch stop layer over the patterned first dielectric stack before forming the spacer layer; where patterning the spacer layer to selectively remove the spacer layer around the first opening includes etching the spacer layer using a sixth etch that does not remove the second etch stop layer; and where the method further includes removing the second etch stop layer from the first opening using a seventh etch that does not remove the top surface of the channel region before forming the gate electrode.

Example 9: The device or method of any one of Examples 1-8 further includes selectively removing the spacer layer within the field plate aperture using a seventh etch that does not remove the second etch stop layer.

Example 10: The device or method of any one of Examples 1-9 further includes removing the second etch stop layer from the field plate aperture using an eighth etch that does not remove the first dielectric layer or the third dialectic layer.

Example 11: The device or method of any one of Examples 1-10, where a width of the field plate aperture at the third dielectric layer is wider than a width of the second opening in the first dielectric layer and a center of the field plate aperture is offset from a center of the second opening.

Example 12: The device or method of any one of Examples 1-11, where the first and second dielectric layers are formed from a silicon nitride material using low-pressure chemical vapor deposition (LPCVD); and where the first and second etch stop layers are formed from an aluminum oxide material.

Example 13: The device or method of any one of Examples 1-12, where the first etch stop layer, the second etch stop layer, or both the first and second etch stop layers are formed using atomic layer deposition (ALD).

Example 14: The device or method of any one of Examples 1-13, further includes thermally annealing the substrate at a temperature greater than 300 centigrade to reduce charge trapping in remaining portions of the first etch stop layer.

Example 15: The device or method of any one of Examples 1-14, where patterning the spacer layer to selectively remove the spacer layer above the first opening leaves a portion of the spacer layer intact along a sidewall of the first opening.

The preceding detailed description and Figures referenced therein are examples. They are illustrative in nature and are not intended to limit the embodiments of the Disclosure and uses of such embodiments. It should therefore be understood that embodiments of this Disclosure are not limited in their application to the details of construction and the arrangement of components set forth in the preceding Description or illustrated in the accompanying Figures.

The connecting lines shown in the various figures contained herein are intended to represent exemplary functional relationships and/or physical couplings between the various elements. It should be noted that many alternative or additional functional relationships or physical connections may be present in one or more embodiments of the Disclosure.

As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description. It is to be understood that other phraseology and terminology used herein is for the purpose of description and should not be regarded as limiting.

The terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. Herein, "A, B, and/or C" is defined as "A or B or C" or any combination of A, B, or C.

As used herein, unless expressly stated otherwise, "connected" means that one element is directly joined to (or directly communicates with) another element in an electrical or non-electrical manner, and not necessarily mechanically. Likewise, unless expressly stated otherwise, "coupled" means that one element is directly or indirectly joined to (or directly or indirectly communicates with) another element in an electrical or non-electrical manner, and not necessarily mechanically. Thus, although the schematic illustrations of the figures may depict exemplary arrangements of elements, additional intervening elements, devices, features, or components may be present in one or more embodiments of the depicted subject matter.

The terms "first," "second" and other such numerical terms referring to structures do not imply a sequence or order unless clearly indicated by the context. Thus, the terms "first," "second," "third," "fourth" and the like in the description and the claims, if any, may be used for distinguishing between similar elements and not necessarily for describing a particular sequential or chronological order. It is to be understood that numerical terms used herein are interchangeable under appropriate circumstances such that the embodiments of the invention described herein are, for example, capable of operation in sequences other than those illustrated or otherwise described herein.

As used herein the terms "approximate," "approximately," "substantial" and "substantially" mean sufficient to accomplish the stated purpose in a practical manner and that minor imperfections, if any, are not significant for the stated purpose. Along these lines, when used with references to measurable quantities including, but not limited to, dimensions, these terms mean that the quantities are equal to the values stated subject to accepted tolerances of any methods or apparatus chosen to fabricate the described structures or measure the quantities or dimensions described.

While at least one exemplary embodiment has been presented in the foregoing detailed description, it should be appreciated that a vast number of variations exist. It should also be appreciated that exemplary embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A method of fabricating a semiconductor device, the method comprising:
receiving a semiconductor substrate having a channel region operable as a transistor channel, wherein the channel region extends between a first current terminal region at a first end of the channel region and a second current terminal region at a second end of the channel region, wherein a first dielectric stack is disposed directly on a top surface of the channel region;
patterning the first dielectric stack to simultaneously form:
a first opening in the first dielectric stack located between the first end of the channel region and the second end of the channel region;
a second opening that passes through at least part of the first dielectric stack between the first opening and the second end of the channel region;
forming a dielectric spacer layer above the patterned first dielectric stack and within the first and second apertures;
patterning the spacer layer to selectively remove the spacer layer above the first opening;
forming an electrically conductive gate electrode that directly contacts the top surface of the channel region in a gate aperture having a location defined by the first opening;
forming an interlayer dielectric layer above the gate electrode;
selectively removing the interlayer dielectric layer to form a field plate aperture with a location defined by the second opening; and
forming an electrically-conductive field plate electrode in the field plate aperture;
wherein the first dielectric stack comprises:
a first dielectric layer; and
a first etch stop layer disposed directly on the first dielectric layer.

2. The method of Claim 1, further comprising:
forming a second dielectric stack directly on the spacer layer that comprises a second etch stop layer and a second dielectric layer directly on the second etch stop layer;
patterning the second dielectric stack to form a patterned portion of the second dielectric stack that exposes the spacer layer in the first aperture by removing the second dielectric layer above the first opening using a first etch that does not remove the etch stop layer and removing the second etch stop layer with a second etch that does not remove the spacer layer; and
patterning the spacer layer to expose the top surface of the channel region in the first opening using a third etch.

3. The method of Claim 2,
wherein the first and second dielectric layers are formed from a silicon nitride material using low-pressure chemical vapor deposition (LPCVD); and
wherein the first and second etch stop layers are formed from an aluminum oxide material.

4. The method of Claim 3,
wherein the first etch stop layer, the second etch stop layer, or both the first and second etch stop layers are formed using atomic layer deposition (ALD).

5. The method of any of Claim 2 to 4, further comprising:
protecting the patterned portion of the second dialectic stack above the second opening from the first, second, and third etches; and
selectively removing at least part of the patterned portion of the second dielectric stack above the second opening by:
selectively removing the second dielectric layer with a fourth etch that does not remove the second etch stop layer; and
selectively removing the second etch stop layer with a fifth etch that does not remove the spacer layer;
wherein a first portion field plate electrode is disposed directly on the spacer layer in the field plate aperture above the second opening.

6. The method of Claim 5, wherein a width of the field plate aperture at the second dielectric layer is wider than a width of the second opening in the first dielectric layer and a center of the field plate aperture is offset from a center of the second opening.

7. The method of any preceding Claim,
wherein the first dielectric stack further comprises a third dielectric layer disposed directly on the first etch stop layer; and
wherein patterning the first dielectric stack comprises:
patterning the third dielectric layer to form the first opening in the third dielectric layer using a first etch that does not remove the first etch stop layer;
patterning the third dielectric layer to form the second opening in the third dielectric layer using the first etch;
removing the first etch stop layer from the first and second openings using a second etch that does not remove the first dielectric layer;
using a masking material to form a masked portion of the third dielectric layer surrounding the second opening;
forming an exposed portion of the first dielectric layer by selectively removing the remaining third dielectric layer surrounding the masked portion of the third dielectric layer using third etch that does not remove the first etch stop layer;
forming a first opening the first dielectric layer beneath the first opening in the third dielectric layer using a fourth etch that does not remove the top surface of the channel region; and
removing the first etch stop layer from the exposed portion of the first dielectric layer using a fifth etch that does not remove the first dielectric layer.

8. The method of Claim 7, further comprising:
forming a second etch stop layer over the patterned first dielectric stack before forming the spacer layer;
wherein patterning the spacer layer to selectively remove the spacer layer around the first opening includes etching the spacer layer using a sixth etch that does not remove the second etch stop layer; and
wherein the method further comprises removing the second etch stop layer from the first opening using a seventh etch that does not remove the top surface of the channel region before forming the gate electrode.

9. The method of Claim 8, further comprising selectively removing the spacer layer within the field plate aperture using a seventh etch that does not remove the second etch stop layer.

10. The method of Claim 9, further comprising removing the second etch stop layer from the field plate aperture using an eighth etch that does not remove the first dielectric layer or the third dialectic layer.

11. The method of Claim 10, wherein a width of the field plate aperture at the third dielectric layer is wider than a width of the second opening in the first dielectric layer and a center of the field plate aperture is offset from a center of the second opening.

12. The method of any of Claims 7 to 11,
wherein the first and second dielectric layers are formed from a silicon nitride material using low-pressure chemical vapor deposition (LPCVD); and
wherein the first and second etch stop layers are formed from an aluminum oxide material.

13. The method of any of Claims 7 to 12, wherein the first etch stop layer, the second etch stop layer, or both the first and second etch stop layers are formed using atomic layer deposition (ALD).

14. The method of any preceding Claim, further comprising thermally annealing the substrate at a temperature greater than 300° centigrade to reduce charge trapping in remaining portions of the first etch stop layer.

15. The method any preceding claim, wherein patterning the spacer layer to selectively remove the spacer layer above the first opening leaves a portion of the spacer layer intact along a sidewall of the first opening.
